# EUROPEAN PATENT APPLICATION

(11) **EP 4 675 673 A2**
(43) Date of publication of application: **07.01.2026**
(21) Application number: 25180123.9
(22) Date of filing: 02.06.2025
(51) Int. Cl.: H01L 21/67

(54) **COATING DEVICE AND COATING METHOD**

(30) Priority: 18.06.2024 JP 2024098064
(71) Applicant: SCREEN Holdings Co., Ltd., Kyoto-shi, Kyoto 602-8585 (JP)
(72) Inventor: TAWARATANI, Yoshinori, Kyoto, 602-8585 (JP); NAGANO, Yuki, Kyoto, 602-8585 (JP); FURUKAWA, Kenta, Kyoto, 602-8585 (JP); MINAI, Taiki, Kyoto, 602-8585 (JP); HOKABE, Toshiyuki, Kyoto, 602-8585 (JP); MATSU, Taiji, Kyoto, 602-8585 (JP); MATSUCHIKA, Keiji, Kyoto, 602-8585 (JP); NISHIMOTO, Masayuki, Kyoto, 602-8585 (JP)
(74) Representative: Kilian Kilian & Partner mbB

(57) **Abstract**

A coating device includes a rotation holding unit that holds and rotates a substrate, an outer peripheral cup and a center cup. The outer peripheral cup receives a coating liquid splashing outwardly of the substrate held and rotated by the rotation holding unit during a coating process for the substrate. The center cup receives the coating liquid falling from an outer peripheral end of the substrate. The coating device further includes a first solvent nozzle and a cup rotation driver. The first solvent nozzle supplies a solvent to a partial area in a circumferential direction of an upper-surface peripheral portion of the substrate held and rotated by the rotation holding unit from a predetermined position above the substrate. The cup rotation driver rotates the center cup about a rotation axis of the rotation holding unit.

## Description

### BACKGROUND

### Technical Field

The present disclosure relates to a coating device and a coating method for forming a coating film on an upper surface of a substrate.

### Description of Related Art

A substrate processing apparatus is used to execute various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell.

As one example of the substrate processing apparatus, there is a coating device that forms a coating film such as a resist film or an anti-reflection film on an upper surface of a substrate. In the coating device, one substrate is held and rotated by a spin chuck, for example. A coating liquid corresponding to the type of a coating film to be formed is supplied to the upper surface of the rotating substrate. The coating liquid supplied onto the substrate spreads over the entire upper surface of the substrate due to a centrifugal force. A coating film is formed when the coating liquid on the substrate is dried.

As described above, when the coating liquid is supplied onto the substrate, part of the coating liquid that has been supplied onto the substrate splashes outwardly of the substrate. Further, part of the remaining coating liquid falls from the outer peripheral end of the substrate. In the coating device, a member for receiving and collecting the coating liquid splashing or falling from the substrate is provided.

For example, a rotation processing device (coating device) described in JP 9-117708 A includes a splashing prevention cup. The splashing prevention cup has an outer cup and a flow straightener, and is arranged so as to surround the substrate held and rotated by the spin chuck when the coating liquid is supplied to the substrate. In this state, the inner peripheral surface of the outer cup faces the outer peripheral end of the substrate. Further, the upper surface of the flow straightener extends radially outwardly and obliquely downwardly from a position below the outer peripheral end of the substrate. Thus, the coating liquid splashing from the substrate is received by the inner peripheral surface of the outer cup. Further, the coating liquid falling from the substrate is received by the upper surface of the flow straightener. The coating liquid received by the splashing prevention cup flows downwardly along the inner peripheral surface of the outer cup and the upper surface of the flow straightener to be collected.

In the meantime, when the coating liquid remains on the inner peripheral surface of the outer cup and the upper surface of the flow straightener, the shape of a space surrounding the substrate may be changed due to deposits of the coating liquid. The change in shape of the space causes an unintended airflow in the space. Further, particles and the like caused by residue of the coating liquid may splash around the substrate.

As such, in the above-mentioned rotation processing device, a cup cleaning member for cleaning the splashing prevention cup is provided. When the splashing prevention cup is cleaned by the cup cleaning member, the cleaning liquid is injected from the cup cleaning member to the entire inner peripheral surface of the outer cup and the entire upper surface of the flow straightener with the substrate not held by the spin chuck.

### SUMMARY

In recent years, with increases in density and integration of devices, it has been required to increase the thickness of a coating film to be formed on a substrate. In order to form a coating film having a large thickness, a coating liquid having a high viscosity is used. It is not easy to cause the coating liquid having a high viscosity to flow smoothly on an upper surface of a flow straightener. Therefore, in a case in which a coating liquid having a high viscosity is used in the above-mentioned rotation processing device, solid matter of the coating liquid is likely to remain on the upper surface of the flow straightener. When a large amount of solid matter of the coating liquid adheres to the upper surface of the flow straightener, complicated maintenance work by a user is required.

The splashing prevention cup is normally cleaned by the cup cleaning member every predetermined period of time (48 hours, for example) or each time a predetermined number of substrates are processed. As such, it is considered that, the frequency of cleaning for the splashing prevention cup by the cup cleaning member is increased such that maintenance work is not necessary.

However, in the above-mentioned rotation processing device, a coating film cannot be formed at the same time as the splashing prevention cup is cleaned. Therefore, when the frequency of cleaning for the splashing prevention cup is increased, the working rate of the rotation processing device is reduced. Further, a solvent is usually used as a cleaning liquid for dissolving and removing the coating liquid. Therefore, an increasing in frequency of cleaning for the splashing prevention cup increases the consumption of the solvent. An increase in consumption of the solvent is not preferable from the viewpoint of the cost of substrate processing and environmental impact.

An object of the present disclosure is to provide a coating device and a coating method that enable improvement of cleanliness of a cup while a reduction in work efficiency of the coating device is suppressed and an increase in consumption of a solvent used for cleaning for the cup is suppressed.

A coating device according to one aspect of the present disclosure that forms a coating film on a substrate by supplying a coating liquid to an upper surface of the substrate, with the substrate being at least partially circular, includes a rotation holder that holds the substrate and rotates the held substrate about a reference axis extending in an upward-and-downward direction, an outer peripheral cup provided around the substrate held by the rotation holder, a center cup arranged inwardly of the outer peripheral cup and below the substrate held by the rotation holder, a first solvent nozzle that supplies a solvent to a partial area in a circumferential direction of an upper-surface peripheral portion of the substrate rotated by the rotation holder from a predetermined first position above the substrate held by the rotation holder, and a cup rotation driver that rotates the center cup about the reference axis.

A coating method according to another aspect of the present disclosure is a method of forming a coating film on a substrate by using a coating device, with the substrate being at least partially circular, wherein the coating device further includes a rotation holder that holds the substrate and rotates the held substrate about a reference axis extending in an upward-and-downward direction, an outer peripheral cup provided around the substrate held by the rotation holder, a center cup arranged inwardly of the outer peripheral cup and below the substrate held by the rotation holder, and a first solvent nozzle that supplies a solvent to a partial area in a circumferential direction of an upper-surface peripheral portion of the substrate rotated by the rotation holder from a predetermined first position above the substrate held by the rotation holder, and the coating method includes a first step of forming the coating film on an entire upper surface of one substrate by supplying a coating liquid to an upper surface of the one substrate held and rotated by the rotation holder, a second step of supplying a solvent from the first solvent nozzle to a partial area in a circumferential direction of an upper-surface peripheral portion of the one substrate held and rotated by the rotation holder after the coating film is formed on the entire upper surface of the one substrate, and a third step of rotating the center cup about the reference axis after the first step and the second step are performed on the one substrate and until the first step and the second step are performed on a next substrate.

With the present disclosure, a reduction in work efficiency of a coating device is suppressed, an increase in consumption of a solvent used for cleaning a cup is suppressed, and cleanliness of the cup is improved.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic longitudinal cross-sectional view showing the basic configuration of a coating device according to one embodiment of the present disclosure;
Fig. 2 is an exploded cross-sectional view of a rotation holding device;
Fig. 3 is a diagram for explaining the configuration of an upper cup;
Fig. 4 is a diagram for explaining the configuration of a lower cup;
Fig. 5 is a diagram for explaining the configuration of a center cup;
Fig. 6 is a diagram for explaining the configuration of a base member;
Fig. 7 is a schematic longitudinal cross-sectional view for explaining the work in a coating process for a substrate in the coating device;
Fig. 8 is a schematic longitudinal cross-sectional view for explaining the work in the coating process for a substrate in the coating device;
Fig. 9 is a schematic longitudinal cross-sectional view for explaining the work in the coating process for a substrate in the coating device;
Fig. 10 is a schematic longitudinal cross-sectional view for explaining the work in the coating process for a substrate in the coating device;
Fig. 11 is a schematic longitudinal cross-sectional view for explaining the work in the coating process for a substrate in the coating device;
Fig. 12 is a schematic longitudinal cross-sectional view for explaining the work in the coating process for a substrate in the coating device;
Fig. 13 is a schematic longitudinal cross-sectional view for explaining the work in the coating process for a substrate in the coating device;
Fig. 14 is a schematic longitudinal cross-sectional view for explaining the work in a cup cleaning process in the coating device;
Fig. 15 is a block diagram showing the configuration of a control system of the coating device of Fig. 1; and
Fig. 16 is a diagram schematically showing a result of comparison between a contamination state of a center cup according to an inventive example and a contamination state of a center cup according to a comparative example.

### DETAILED DESCRIPTION

A coating device (coater) and a coating method according to one embodiment of the present disclosure will be described below with reference to the drawings. In the following description, a substrate refers to a substrate for an FPD (Flat Panel Display) that is used for a liquid crystal display device, an organic EL (Electro Luminescence) display device or the like, a semiconductor substrate, a substrate for an optical disc, a substrate for a magnetic disc, a substrate for a magneto-optical disc, a substrate for a photomask, a ceramic substrate, a substrate for a solar cell or the like. A substrate described below is a substrate that is at least partially circular and is specifically a circular substrate in which a notch for positioning is formed in a portion of the outer peripheral end.

### 1. Basic Configuration of Coating Device

A coating device according to one embodiment of the present disclosure is used for executing a coating process of forming a coating film on an upper surface of a substrate by supplying a coating liquid onto the upper surface of the substrate. The coating process according to the present embodiment includes a process of locally removing a coating film formed on an outer peripheral end of the substrate.

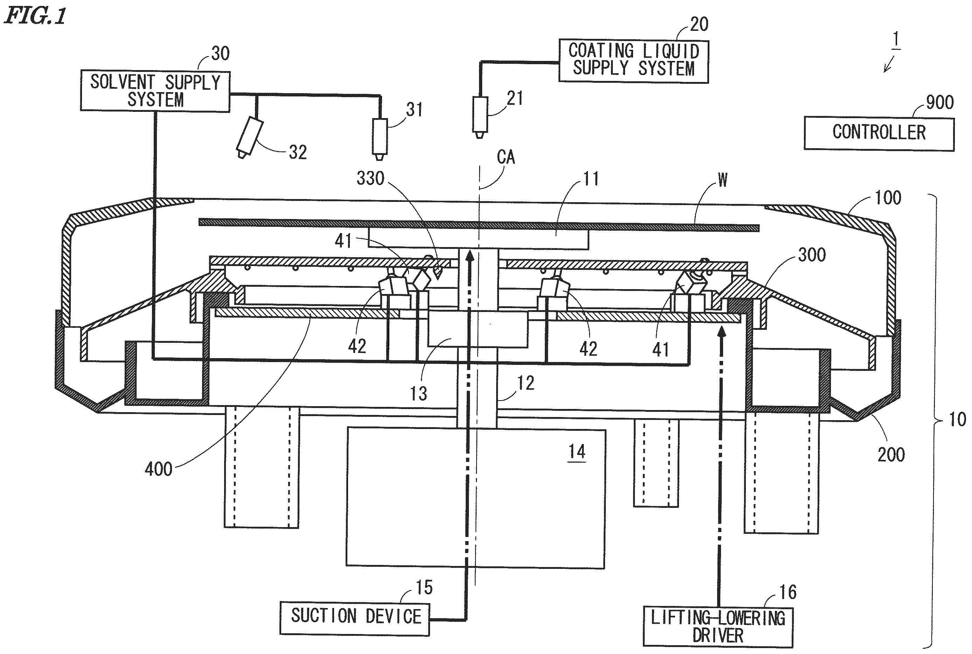

Fig. 1 is a schematic longitudinal cross-sectional view showing the basic configuration of a coating device according to one embodiment of the present disclosure. As shown in Fig. 1, the coating device 1 according to the present embodiment mainly includes a rotation holding device (spin chuck) 10, a coating liquid supply system 20, a coating liquid nozzle 21, a solvent supply system 30, a pre-wet nozzle 31, a first solvent nozzle 32 and a controller 900. These constituent elements are accommodated in a chamber (not shown), for example.

The rotation holding device 10 includes a holder 11, a rotation shaft 12, a cylindrical member 13, a rotation driver 14 and a suction device 15. The rotation driver 14 is a motor, for example, and is fixed to the bottom portion of the chamber. The rotation shaft 12 is a rotation shaft of the rotation driver 14 and extends upwardly from the upper end portion of the rotation driver 14. In the following description, an axis passing through the center axis of the rotation shaft 12 in the coating device 1 is referred to as a reference axis CA.

The holder 11 is connected to the upper end portion of the rotation shaft. The holder 11 is configured to be capable of holding the substrate W by suction. In the rotation shaft 12, a suction path for holding the substrate W by suction in the holder 11 is formed. The suction path is connected to the suction device 15. The suction device 15 works with the substrate W placed on the holder 11, so that the substrate W is held by suction by the holder 11. The rotation driver 14 works in this state, so that the substrate W rotates about the reference axis CA. The cylindrical member 13 is provided at the substantially center portion of the rotation shaft 12 in an upward-and-downward direction. Details of the cylindrical member 13 will be described below.

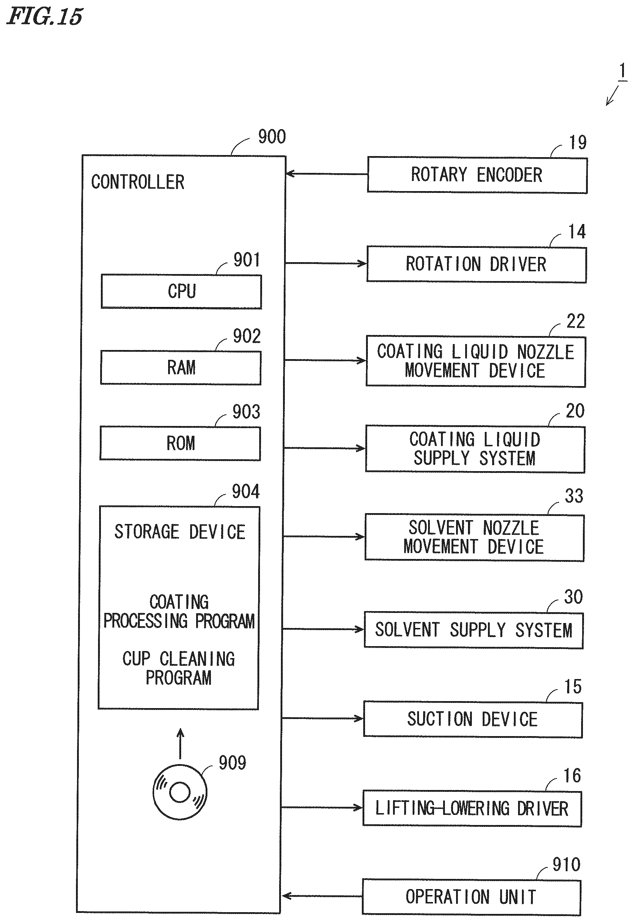

The coating liquid nozzle 21 is supported by a coating liquid nozzle movement device 22 (Fig. 15), described below, to be movable between a coating position above the rotation holding device 10 in the chamber of the coating device 1 and a waiting position sideward of the rotation holding device 10.

The coating liquid supply system 20 includes one or a plurality of fluid-related elements such as a pipe, a joint, a valve, a pump and a tank, and is connected to a processing liquid supply source. With the substrate W held by the holder 11 being rotated and with the coating liquid nozzle 21 being arranged at the coating position, the coating liquid supply system 20 supplies the coating liquid from the coating liquid supply source to the coating liquid nozzle 21. Thus, the coating liquid is discharged from the coating liquid nozzle 21 onto the upper surface of the substrate W, and a coating film is formed on the entire upper surface of the substrate W. The coating liquid used in the coating device 1 according to the present embodiment is a coating liquid for a resist film (resist liquid) or a coating liquid for an anti-reflection film (anti-reflection liquid), for example.

The pre-wet nozzle 31 is supported by a solvent nozzle movement device 33 (Fig. 15), described below, to be movable between a pre-wet position above the rotation holding device 10 in the chamber of the coating device 1 and a waiting position sideward of the rotation holding device 10. Further, the first solvent nozzle 32 is supported by a solvent nozzle movement device 33 (Fig. 15), described below, to be movable between a peripheral-portion processing position above the rotation holding device 10 in the chamber of the coating device 1 and a waiting position sideward of the rotation holding device 10.

The solvent supply system 30 includes one or a plurality of fluid-related elements such as a pipe, a joint, a valve, a pump and a tank, and is connected to a solvent supply source. Immediately before the coating liquid is supplied to the rotating substrate W, the pre-wet nozzle 31 is arranged at the pre-wet position. With the rotation of the substrate W continuing, the solvent supply system 30 supplies a solvent from the solvent supply source to the pre-wet nozzle 31. Thus, the solvent is discharged from the pre-wet nozzle 31 to the upper surface of the substrate W, and the upper surface of the substrate W before the coating film is formed is wetted with the solvent (pre-wetting).

Further, after the coating film is formed on the entire upper surface of the substrate W, the first solvent nozzle 32 is arranged at the peripheral-portion processing position. With the rotation of the substrate W continuing, the solvent supply system 30 supplies the solvent from the solvent supply source to the first solvent nozzle 32. Thus, the solvent is discharged from the first solvent nozzle 32 to a partial area in a circumferential direction of the upper-surface peripheral portion of the substrate W. The solvent used in the coating device 1 can dissolve the coating film formed on the substrate W. Therefore, out of the coating film formed on the substrate W, a portion formed in the upper-surface peripheral portion and the outer peripheral end of the substrate W is removed by the solvent.

In the rotation holding device 10, second solvent nozzles 41 and third solvent nozzles 42 are provided at positions below the holder 11. In addition to the pre-wet nozzle 31 and the first solvent nozzle 32, the solvent supply system 30 can supply the solvent to the second solvent nozzles 41 and the third solvent nozzles 42. The supply of the solvent from the solvent supply system 30 to the second solvent nozzles 41 and the third solvent nozzles 42 will be described below.

When a processing liquid such as the coating liquid or the solvent is supplied to the substrate W held and rotated by the holder 11, the supplied processing liquid splashes radially from the outer peripheral end of the substrate W about the reference axis CA. As such, the rotation holding device 10 has a liquid collection mechanism for receiving and collecting the processing liquid splashing from the substrate W and discharging the processing liquid from the coating device 1. Details of the liquid collection mechanism will be described below. The controller 900 controls the work of the each component of the rotation holding device 10, the coating liquid supply system 20 and the solvent supply system 30. Details of the controller 900 will be described below.

### 2. Details of Configuration of Rotation Holding Device 10

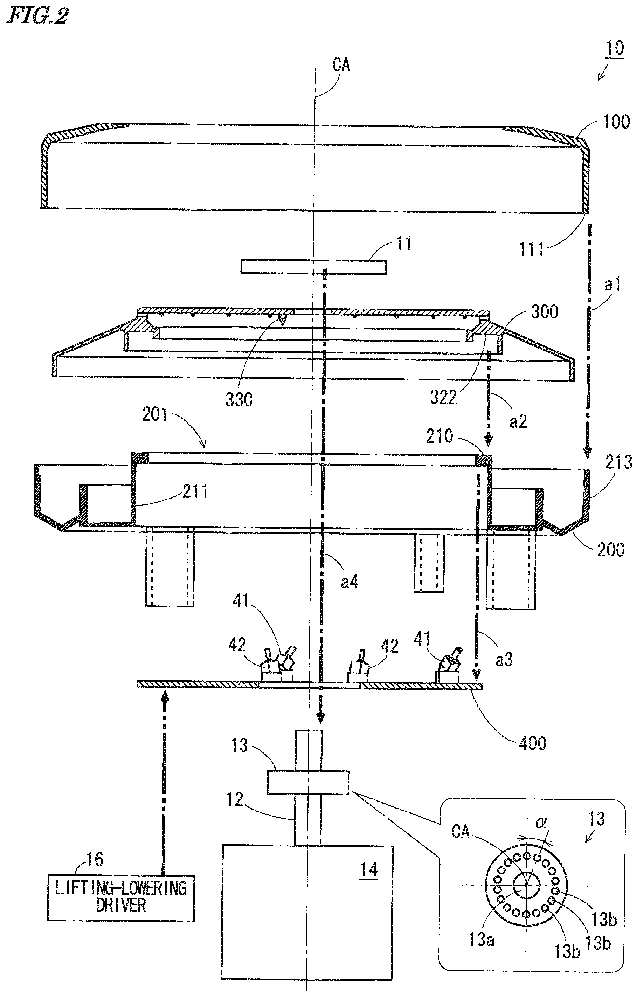

Fig. 2 is an exploded cross-sectional view of the rotation holding device 10. As shown in Fig. 2, the rotation holding device 10 includes the holder 11, the rotation shaft 12, the cylindrical member 13 and the rotation driver 14, described above. Further, the rotation holding device 10 further includes a lifting-lowering driver 16, an upper cup 100, a lower cup 200, a center cup 300 and a base member 400 as constituent elements of the liquid collection mechanism. In Fig. 2, the suction device 15 of Fig. 1 is not shown. Further, in Fig. 2, only the lifting-lowering driver 16 is shown in a block.

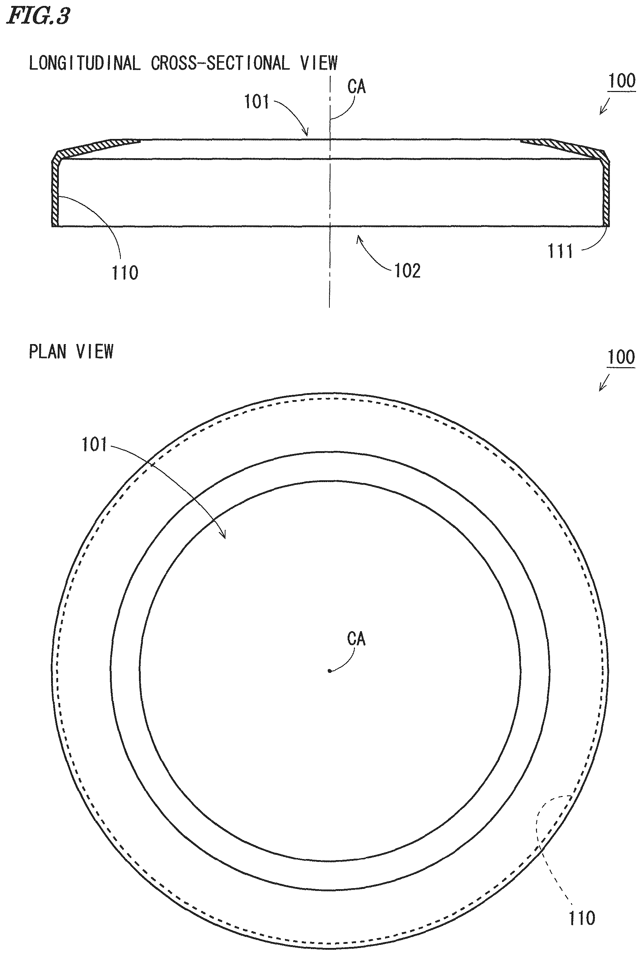

Fig. 3 is a diagram for explaining the configuration of the upper cup 100. In Fig. 3, a longitudinal cross-sectional view of the upper cup 100 is shown in the upper field, and a plan view of the upper cup 100 is shown in the lower field. As shown in Fig. 3, the upper cup 100 has a flat cylindrical shape extending in the upward-and-downward direction. The inner diameters of the upper end portion and portions in the vicinity of the upper end portion of the upper cup 100 are locally smaller than those of other portions of the upper cup 100. Therefore, the upper cup 100 has an inner peripheral surface 110 in which the upper end portion and portions in the vicinity of the upper end portion are locally inwardly inclined. Further, an upper opening 101 of the upper cup 100 is smaller than a lower opening 102 of the upper cup 100.

The diameter of the upper opening 101 in plan view, that is, the minimum value of the inner diameter of the upper cup 100 is slightly larger than the diameter of the substrate W to be processed. As described below, the upper cup 100 is connected to the lower cup 200. The upper cup 100 has a circular lower end portion 111 as a portion to be connected to the lower cup 200.

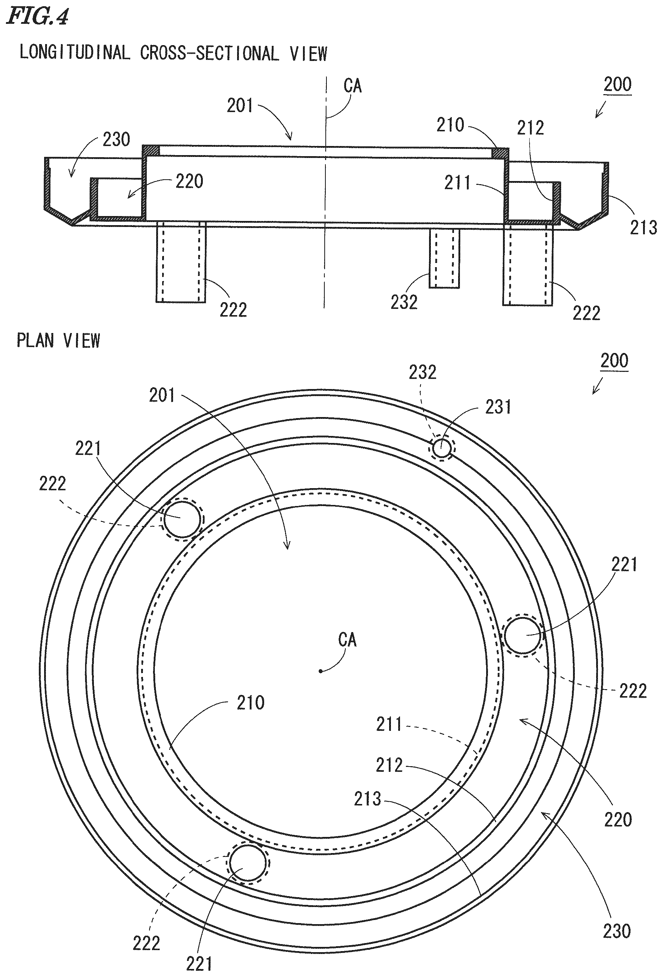

Fig. 4 is a diagram for explaining the configuration of the lower cup 200. In Fig. 4, a longitudinal cross-sectional view of the lower cup 200 is shown in the upper field, and a plan view of the lower cup 200 is shown in the lower field. As shown in Fig. 4, the lower cup 200 has an annular shape including a center opening 201 in plan view. Further, the lower cup 200 has an annular supporting portion 210, a gas flow groove 220 and a liquid collection groove 230. The annular supporting portion 210 has an annular shape surrounding the center opening 201 in plan view. The gas flow groove 220 has an annular shape surrounding the annular supporting portion 210 in plan view. The liquid collection groove 230 has an annular shape surrounding the gas flow groove 220 in plan view.

The inner peripheral end of the annular supporting portion 210 forms the circular center opening 201 centered at the reference axis CA. A cylindrical first peripheral wall 211 is formed so as to extend downwardly from the outer peripheral end of the annular supporting portion 210. Further, a cylindrical second peripheral wall 212 is provided outwardly of the second peripheral wall 212 so as to draw a concentric circle with respect to the first peripheral wall 211 in plan view. Further, a cylindrical third peripheral wall 213 is provided outwardly of the second peripheral wall 212 so as to draw a concentric circle with respect to the first peripheral wall 211 and the second peripheral wall 212 in plan view.

The gas flow groove 220 is formed by the first peripheral wall 211 and the second peripheral wall 212, and has a bottom surface portion connecting the lower end portion of the first peripheral wall 211 to the lower end portion of the second peripheral wall 212. In the bottom surface portion of the gas flow groove 220, three exhaust holes 221 are formed at equal angular intervals with respect to the reference axis CA. Each exhaust hole 221 is a through hole. In a portion of the bottom surface portion of the gas flow groove 220 where each exhaust hole 221 is formed, a tubular exhaust pipe connection portion 222 extending downwardly by a certain distance is provided. An exhaust system (not shown) is connected to the exhaust pipe connection portion 222. The exhaust system includes an exhaust pipe, exhaust facility of a factory, and the like, and guides an atmosphere in the gas flow groove 220 to the outside of the coating device 1.

The liquid collection groove 230 is formed by the second peripheral wall 212 and the third peripheral wall 213, and has a bottom surface portion connecting the lower end portion of the second peripheral wall 212 to the lower end portion of the third peripheral wall 213. A drain hole 231 is formed in part of the bottom surface portion of the liquid collection groove 230. The drain hole 231 is a through hole. Further, in a portion of the bottom surface portion of the liquid collection groove 230 where the drain hole 231 is formed, a tubular drain pipe connection portion 232 extending downwardly by a certain distance is provided. A drain system (not shown) is connected to the drain pipe connection portion 232. The drain system includes a drain pipe, drain facility of a factory, and the like, and guides various processing liquids collected in the liquid collection groove 230 to the outside of the coating device 1 as described below.

The inner diameter of the upper end portion of the third peripheral wall 213 is equal to or substantially equal to the outer diameter of the lower end portion 111 of the upper cup 100. Further, the upper end portion of the third peripheral wall 213 is configured such that the lower end portion 111 of the upper cup 100 can be inserted into the upper end portion of the third peripheral wall 213 by a certain depth from above the upper end portion of the third peripheral wall 213. When the rotation holding device 10 is assembled, the center cup 300 is arranged between the upper cup 100 and the lower cup 200, and the lower end portion 111 of the upper cup 100 is inserted into the third peripheral wall 213 of the lower cup 200 (see the thick one-dot and dash arrow a1 of Fig. 2). Thus, the upper cup 100 and the lower cup 200 are integrally connected to each other.

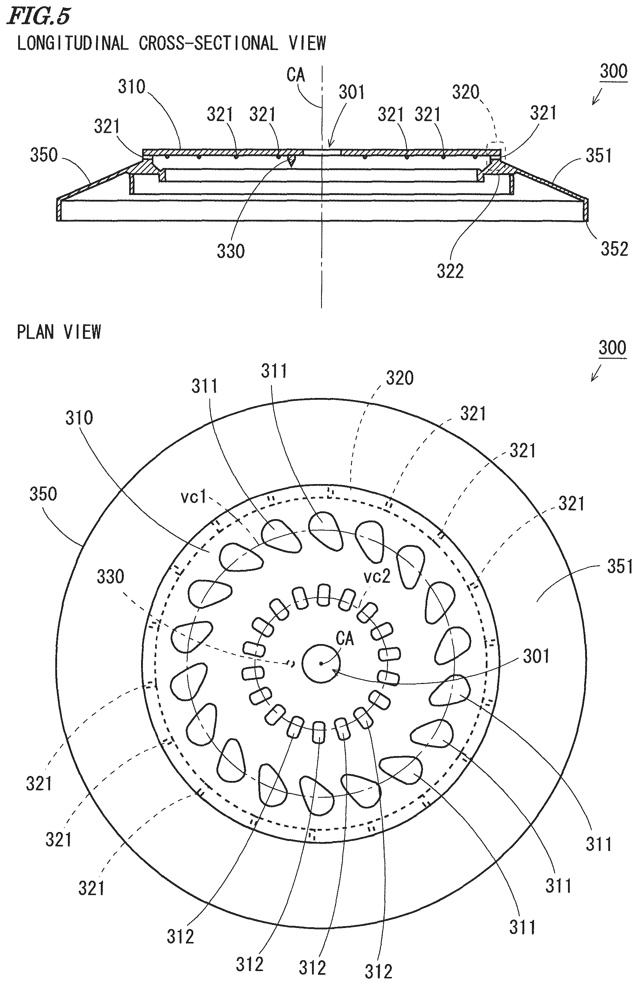

Fig. 5 is a diagram for explaining the configuration of the center cup 300. In Fig. 5, a longitudinal cross-sectional view of the center cup 300 is shown in the upper field, and a plan view of the center cup 300 is shown in the lower field. The center cup 300 has the configuration in which a cup cleaning portion 310 and a center cup main body 350 are integrally molded.

The cup cleaning portion 310 has a disc shape. The outer diameter of the cup cleaning portion 310 is slightly smaller than the diameter of the substrate W to be processed. In the center portion of the cup cleaning portion 310 through which the reference axis CA passes, a circular center opening 301 is formed. The inner diameter of the cup cleaning portion 310 (the diameter of the center opening 301) is larger than the diameter of the rotation shaft 12 in Fig. 1 and smaller than the outer diameter of the cylindrical member 13 in Fig. 1. Thus, a portion of the rotation shaft 12 located above the cylindrical member 13 can be inserted into the center opening 301. In a portion of the lower surface of the cup cleaning portion 310 in the vicinity of the center opening 301, a bar-shaped downward projection 330 projecting downwardly from the lower surface of the cup cleaning portion 310 by a certain distance is provided.

Here, the configuration of the cylindrical member 13 of Fig. 1 will be described. In Fig. 2, a plan view of the cylindrical member 13 is shown in the balloon. As shown in the plan view in the balloon of Fig. 2, the cylindrical member 13 is a flat cylindrical member and has an annular upper end surface. Further, the cylindrical member 13 has a shaft attachment hole 13a and a plurality of vertical holes 13b.

The shaft attachment hole 13a is a through hole extending along the axial center of the cylindrical member 13, and is formed such that the rotation shaft 12 can be inserted therein. With the rotation shaft 12 inserted into the shaft attachment hole 13a, the cylindrical member 13 is attached to a predetermined portion (substantially the center portion in the upward-and-downward direction) in the rotation shaft 12. With the cylindrical member 13 attached to the rotation shaft 12, the cylindrical member 13 is fixed not to be movable in the axial direction and not to be rotatable in the circumferential direction with respect to the rotation shaft 12.

The plurality of vertical holes 13b are formed so as to surround the shaft attachment hole 13a in the upper end surface of the cylindrical member 13. Further, the plurality of vertical holes 13b are arranged at intervals of a prescribed angle α with respect to the reference axis CA. The prescribed angle α is larger than 0° and smaller than 360°, and is 20°, for example. The downward projection 330 of the center cup 300 is provided so as to be insertable into each of the plurality of vertical holes 13b (see the balloon in Fig. 2) of the cylindrical member 13 in accordance with the positional relationship between the center cup 300 and the cylindrical member 13 in the upward-and-downward direction.

For example, in a case in which the center cup 300 and the cylindrical member 13 are close enough to each other to come into contact with each other, the downward projection 330 of the center cup 300 is inserted into any one of the plurality of vertical holes 13b of the cylindrical member 13. In this case, the center cup 300 rotates together with the rotation shaft 12 when the rotation shaft 12 rotates. On the other hand, in a case in which the center cup 300 and the cylindrical member 13 are largely spaced apart from each other, the downward projection 330 of the center cup 300 is located above the cylindrical member 13. In this case, even when the rotation shaft 12 rotates, the center cup 300 does not rotate together with the rotation shaft 12.

As shown in Fig. 5, in the outer peripheral end of the cup cleaning portion 310, a cleaning peripheral wall 320 extending by a minute distance in the upward-and-downward direction is formed. In the cleaning peripheral wall 320, a plurality (18 in the present example) of injection ports 321 are formed at equal angular intervals with respect to the reference axis CA. Each injection port 321 is a through hole that causes the space located inwardly of the cleaning peripheral wall 320 to communicate with the space located outwardly of the cleaning peripheral wall 320 in plan view.

In the cup cleaning portion 310, a plurality of first through holes 311 are formed at equal angular intervals with respect to the reference axis CA so as to be arranged on a first virtual circle vc1 centered at the reference axis CA in plan view. Further, a plurality of second through holes 312 are formed at equal angular intervals with respect to the reference axis CA so as to be arranged on a second virtual circle vc2 smaller than the first virtual circle vc1.

The angular interval between two of the first through holes 311 adjacent to each other on the first virtual circle vc1 is equal to the above-mentioned prescribed angle α (Fig. 2). The angular interval between two of the second through holes 312 adjacent to each other on the second virtual circle vc2 is also equal to the prescribed angle α. Therefore, in a case in which the prescribed angle α is 20°, the number of the first through holes 311 and the number of the second through holes 312 formed in the cup cleaning portion 310 are both 18.

Each first through hole 311 is formed such that at least part of the second solvent nozzle 41, described below, can be inserted from below. Further, each second through hole 312 is formed such that at least part of the third solvent nozzle 42, described below, can be inserted from below.

The center cup main body 350 is annular in plan view. Further, similarly to the outer peripheral surface of a truncated cone, the center cup main body 350 has a cylindrical shape (an umbrella shape with an upper half portion missing) that is formed such that its diameter gradually increases from above to below. Therefore, the center cup main body 350 has an upper surface 351 formed so as to extend obliquely downwardly in a direction away from the reference axis CA from the upper end portion to the lower end portion of the center cup main body 350. In other words, the center cup main body 350 has the upper surface 351 that faces outwardly and obliquely upwardly.

In the center cup 300, the lower end portion of the cleaning peripheral wall 320 of the cup cleaning portion 310 and the upper end portion of the center cup main body 350 are integrally connected to each other. In a portion of the lower surface of the center cup main body 350 located in the vicinity of the upper end portion of the center cup main body 350, an annular supported portion 322 is formed so as to be directed downwardly. The shape of the annular supported portion 322 is formed so as to correspond to the shape of the annular supporting portion 210 (Fig. 4) of the lower cup 200. Specifically, the annular supported portion 322 and the annular supporting portion 210 are formed to have substantially the same shape. Therefore, the annular supported portion 322 comes into contact with the annular supporting portion 210, so that the center cup 300 can be supported on the lower cup 200. When the rotation holding device 10 is assembled, the center cup 300 is arranged on the lower cup 200 such that the annular supported portion 322 is opposite to the annular supporting portion 210 (see the thick one-dot and dash arrow a2 in Fig. 2).

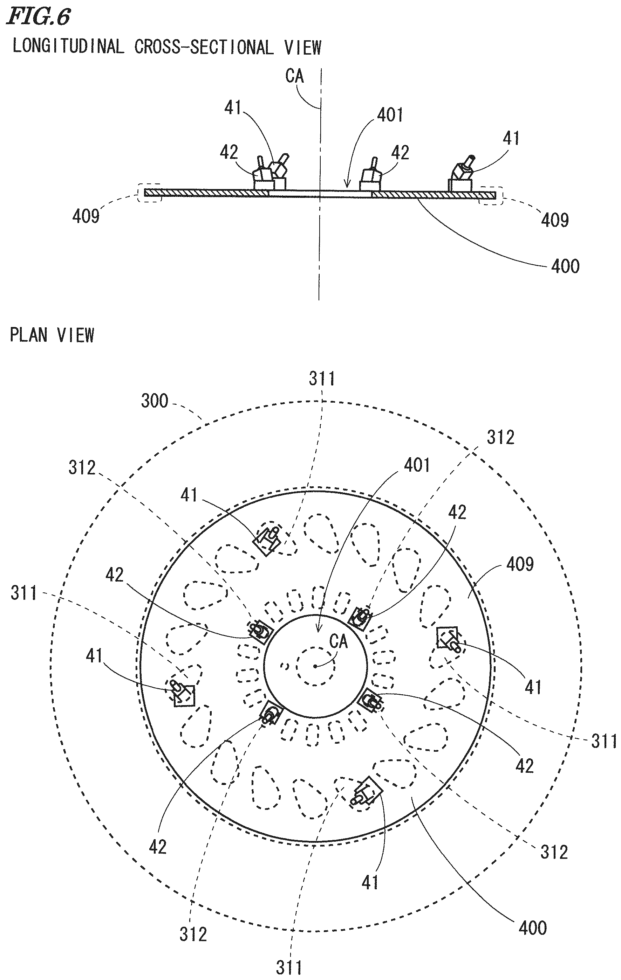

Fig. 6 is a diagram for explaining the configuration of the base member 400. In Fig. 6, a longitudinal cross-sectional view of the base member 400 is shown in the upper field, and a plan view of the base member 400 is shown in the lower field. Further, as described below, in the lower field of Fig. 6, the outer shape of the center cup 300 arranged above the base member 400 is indicated by the dotted line.

As shown in Fig. 6, the base member 400 is a plate-like member, and has an annular shape including a center opening 401 in plan view. The inner diameter of the base member 400 (the diameter of the center opening 401) is larger than the outer diameter of the cylindrical member 13 of Fig. 1. Thus, the rotation shaft 12 and the cylindrical member 13 can be inserted into the center opening 401. The outer diameter of the base member 400 is larger than the inner diameter of the annular supporting portion 210 (Fig. 4) of the center cup 300 and smaller than the inner diameter of the first peripheral wall 211 (Fig. 4) of the center cup 300.

When the rotation holding device 10 is assembled, the lower cup 200 is arranged on the base member 400 such that the lower surface of the annular supporting portion 210 of the lower cup 200 is opposite to the upper-surface peripheral portion of the base member 400 (see the thick one-dot and dash arrow a3 of Fig. 2). In this case, a portion including the upper-surface peripheral portion of the base member 400 (a portion having a certain width from the outer peripheral end of the base member 400) functions as an annular supporter 409. The supporter 409 supports the annular supporting portion 210 of the lower cup 200 from below.

Here, the lifting-lowering driver 16 of Figs. 1 and 2 supports the base member 400 such that the base member 400 is movable in the upward-and-downward direction. Further, the lifting-lowering driver 16 includes an actuator such as an air cylinder or a motor, and adjusts a position (height position) of the base member 400 in the upward-and-downward direction based on the control of the controller 900. With such a configuration, the upper cup 100 and the lower cup 200 are supported to be movable in the upward-and-downward direction by the lifting-lowering driver 16 via the base member 400.

As shown in Fig. 6, on the upper surface of the base member 400, the four second solvent nozzles 41 and the four third solvent nozzles 42 are provided. Each of the four second solvent nozzles 41 is located in the vicinity of the outer peripheral end of the base member 400. Further, the four second solvent nozzles 41 are arranged on a circle centered at the reference axis CA to be sequentially arranged in one direction (circumferential direction) at angular intervals of 80°, 100°, 80° and 100° with respect to the reference axis CA. That is, the four second solvent nozzles 41 are arranged such that, when the angular position of one second solvent nozzle 41 is set to 0° (360°) with respect to the reference axis CA, the angular positions of the other three second solvent nozzles 41 are respectively set to 80°, 180° and 260°.

Each of the four third solvent nozzles 42 is located in the vicinity of the inner peripheral end of the base member 400. Further, the four third solvent nozzles 42 are arranged on a circle centered at the reference axis CA to be sequentially arranged in one direction (circumferential direction) at angular intervals of 80°, 100°, 80° and 100° with respect to the reference axis CA. That is, the four third solvent nozzles 42 are arranged such that, when the angular position of one third solvent nozzle 42 is set to 0° (360°) with respect to the reference axis CA, the angular positions of the other three third solvent nozzles 42 are respectively set to 80°, 180° and 260°.

The solvent supply system 30 of Fig. 1 is connected to each of the solvent nozzles (41, 42) arranged on the base member 400. During a cup cleaning process, described below, the second solvent nozzle 41 discharges a solvent toward the inner peripheral surface of the cleaning peripheral wall 320 (Fig. 5) of the center cup 300. Further, the third solvent nozzle 42 performs so-called back rinsing during the coating process for the substrate W, described below.

As described above, the rotation holding device 10 is assembled, so that the base member 400 is arranged below the center cup 300. During the work of the coating device 1, the distance between the base member 400 and the cup cleaning portion 310 (Fig. 5) of the center cup 300 (the distance in the upward-and-downward direction) changes. Here, when the distance between the base member 400 and the center cup 300 changes, the base member 400 and the center cup 300 have a specific positional relationship in plan view.

The above-mentioned specific positional relationship is the relationship in which at least part of each of the second solvent nozzles 41 overlaps with any one of the plurality of first through holes 311 of the center cup 300 in plan view. Further, the above-mentioned specific positional relationship is the relationship in which at least part of each of the third solvent nozzles 42 overlaps with any one of the plurality of second through holes 312 of the center cup 300 in plan view. Thus, in a case in which the base member 400 is close to the cup cleaning portion 310, at least part of the plurality of solvent nozzles (41, 42) on the base member 400 is inserted into any one of the plurality of through holes (311, 312) of the center cup 300.

As shown in Fig. 2, the holder 11 is fixed onto the rotation shaft 12 after the rotation shaft 12 of the rotation holding device 10 is inserted into the base member 400, the lower cup 200 and the center cup 300 (see the thick one-dot and dash arrow a4 in Fig. 2).

### 3. Work of Coating Device 1 during Coating Process for Substrate W

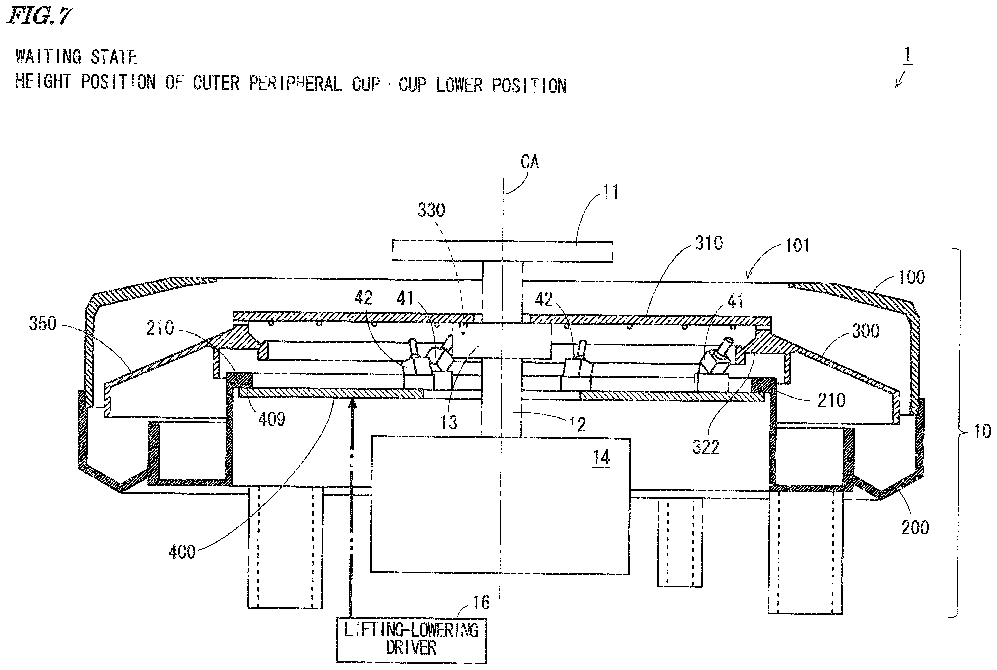

In the following description, an assembly of the upper cup 100 and the lower cup 200 which are integrally connected to each other is suitably referred to as an outer peripheral cup. Figs. 7 to 13 are schematic longitudinal cross-sectional views for explaining the work in the coating process for the substrate W in the coating device 1. Fig. 7 shows a waiting state of the coating device 1 before the substrate W is carried into the coating device 1. In a case in which the coating device 1 is in the waiting state, the base member 400 is supported by the lifting-lowering driver 16 at the lowest height position in the range in which the base member 400 is movable in the upward-and-downward direction.

At this time, as shown in Fig. 7, the annular supporting portion 210 of the lower cup 200 is supported from below by the supporter 409 of the base member 400. Thus, the outer peripheral cup is supported by the lifting-lowering driver 16 via the base member 400. In this manner, the height position of the outer peripheral cup when the coating device 1 is in the waiting state is referred to as a cup lower position. The outer peripheral cup is supported by the lifting-lowering driver 16 while being separated from the rotation shaft 12. Therefore, the outer peripheral cup does not rotate together with the rotation shaft 12 even when the rotation shaft 12 rotates.

With the outer peripheral cup located at the cup lower position, the upper end portion of the upper cup 100 is located below the holder 11. Further, the center cup 300 is supported by the upper end surface of the cylindrical member 13. At this time, the downward projection 330 of the center cup 300 is inserted into any one of the plurality of vertical holes 13b (Fig. 3) of the cylindrical member 13. Thus, the center cup 300 is integrally fixed to the rotation shaft 12 so as to rotate together with the rotation shaft 12 when the rotation shaft 12 rotates. On the other hand, the annular supported portion 322 of the center cup 300 is located above the annular supporting portion 210 of the lower cup 200 by a certain distance. All of the plurality of second solvent nozzles 41 and the plurality of third solvent nozzles 42 are arranged in the space between the base member 400, and the cup cleaning portion 310 of the center cup 300 (space in the gap in the upward-and-downward direction).

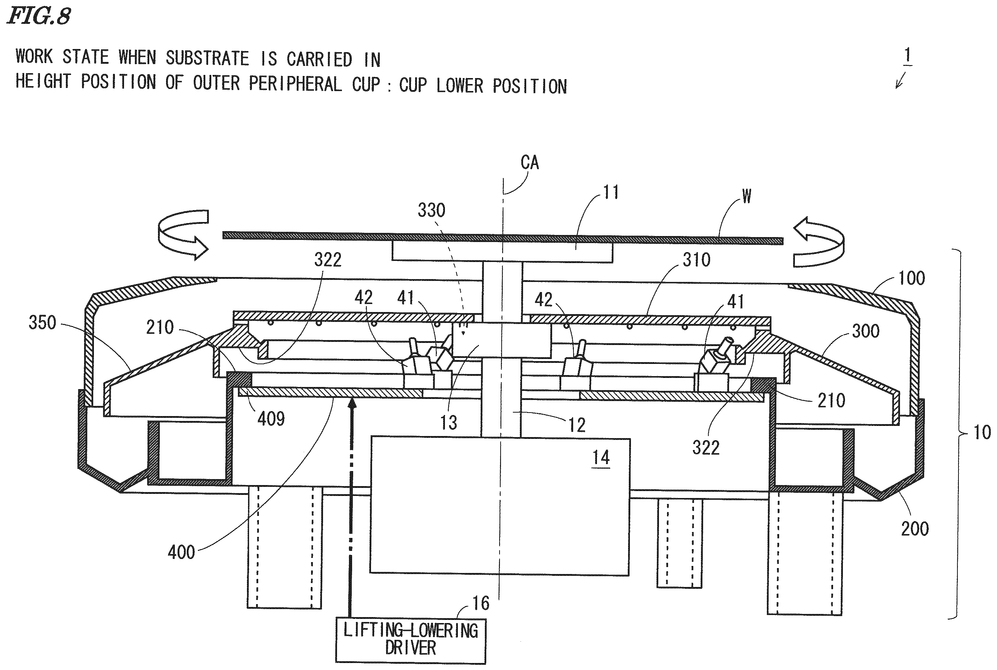

Fig. 8 shows the state of the coating device 1 when the substrate W is carried into the coating device 1 in the waiting state. The substrate W carried into the coating device 1 is positioned at a position above the holder 11 such that the center of the substrate W is located on the reference axis CA. Thereafter, as shown in Fig. 8, the substrate W is placed on the holder 11. Subsequently, the suction device 15 of Fig. 1 works, so that the lower-surface center portion of the substrate W is held by suction by the holder 11. Further, the rotation driver 14 works, so that the rotation shaft 12 rotates counterclockwise (leftwardly) by a prescribed angle a in plan view (see the outlined arrows in Fig. 8). Thus, the center cup 300 rotates counterclockwise by the prescribed angle α in plan view with respect to the outer peripheral cup.

When the processing liquid (the coating liquid and the solvent) is supplied to the substrate W in the coating device 1, the outer peripheral cup is required to be arranged at a height position same as the height position of the substrate W in order to collect the processing liquid splashing from the substrate W. In the following description, a height position at which the outer peripheral cup is to be arranged when the processing liquid is supplied to the substrate W is referred to as a cup upper position. The cup upper position is a height position of the outer peripheral cup when the upper end portion of the upper cup 100 is located above the substrate W held by the holder 11 and the inner peripheral surface 110 of the upper cup 100 is opposite to the outer peripheral end of the substrate W held by the holder 11.

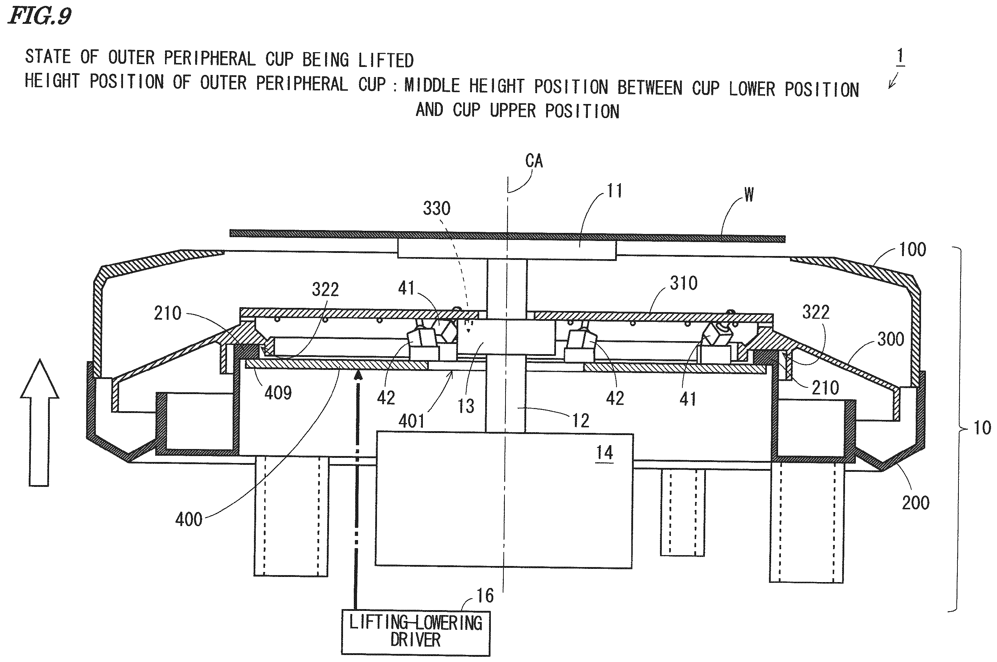

As described above, the substrate W is held by suction on the holder 11, the center cup 300 rotates by the prescribed angle α, and then the outer peripheral cup is lifted to the cup upper position from the cup lower position. Fig. 9 shows the state of the coating device 1 in a period during which the outer peripheral cup is lifted from the cup lower position to the cup upper position.

The outer peripheral cup is lifted by the lifting-lowering driver 16 via the base member 400. When the outer peripheral cup is lifted from the cup lower position, the annular supporting portion 210 of the lower cup 200 is close to the annular supported portion 322 of the center cup 300. Further, as shown in Fig. 9, the annular supporting portion 210 abuts against the annular supported portion 322. Thus, the center cup 300 is supported from below by the lower cup 200. Further, the space between the base member 400 and the cup cleaning portion 310 of the center cup 300 (space in the gap in the upward-and-downward direction) is reduced.

At this time, part (a solvent outlet portion) of each of the plurality of second solvent nozzles 41 is inserted into any one of the plurality of first through holes 311 of the cup cleaning portion 310 (Fig. 5). Further, part (a solvent outlet portion) of each of the plurality of third solvent nozzles 42 is inserted into any one of the plurality of second through holes 312 of the cup cleaning portion 310 (Fig. 5). Thus, the interference between the plurality of solvent nozzles (41, 42) and the cup cleaning portion 310 is prevented.

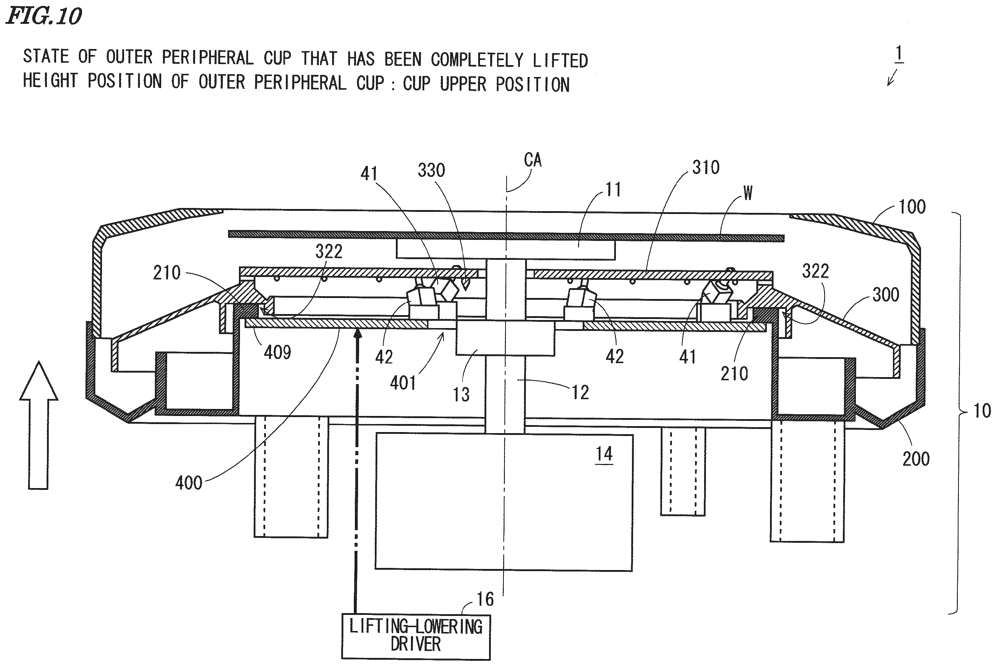

In the latter half of the period in which the outer peripheral cup is lifted from the cup lower position to the cup upper position, the center cup 300 is lifted while being supported by the lower cup 200. Thus, the center cup 300 is spaced apart from the cylindrical member 13. Fig. 10 shows the state of the coating device 1 when the outer peripheral cup is lifted from the cup lower position to the cup upper position. As shown in Fig. 10, with the outer peripheral cup located at the cup upper position, the center cup 300 is supported by the outer peripheral cup and is separated from the rotation shaft 12.

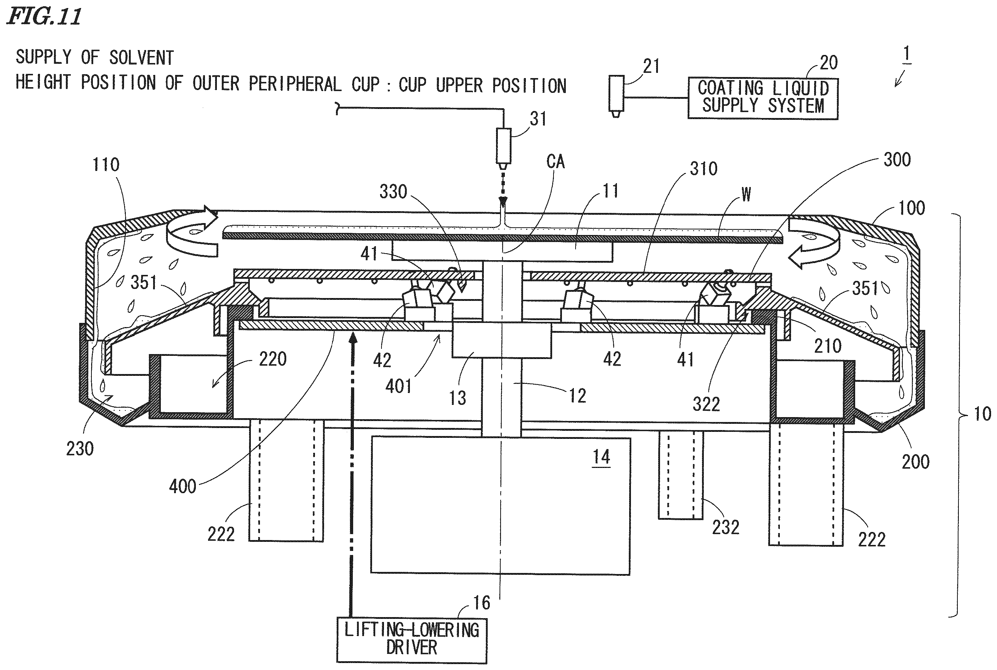

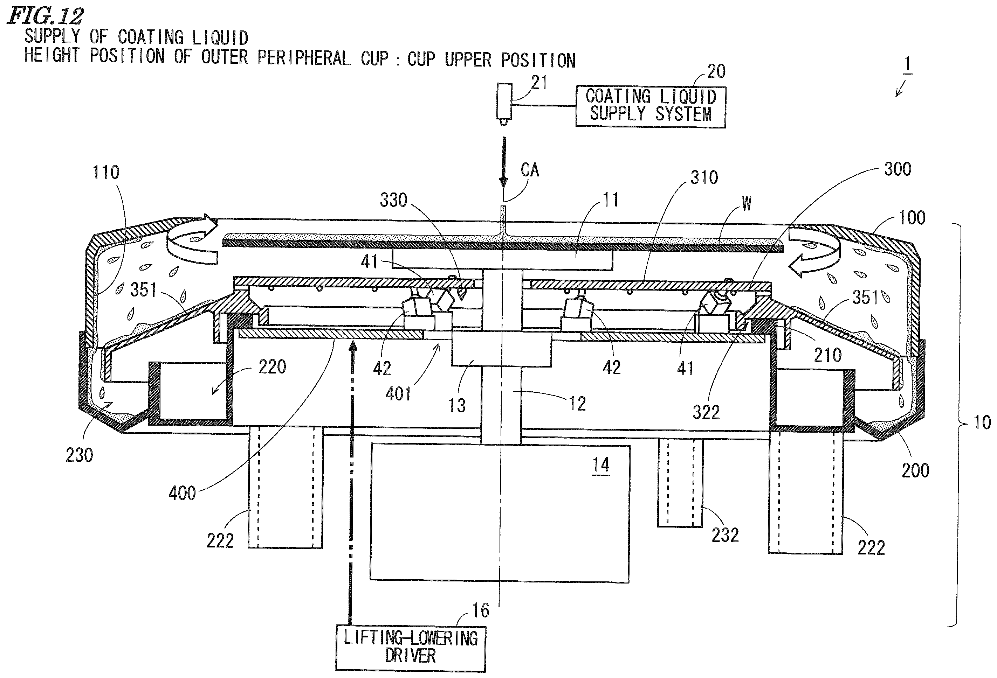

Next, the rotation driver 14 works, so that the substrate W rotates clockwise (rightwardly) in plan view together with the rotation shaft 12. At this time, the outer peripheral cup and the center cup 300 are separated from the rotation shaft 12, thereby not rotating. In this state, the solvent for pre-wetting and the coating liquid are supplied in this order onto the upper surface of the rotating substrate W. Fig. 11 shows the state of the coating device 1 when the solvent for pre-wetting is supplied to the substrate W. Further, Fig. 12 shows the state of the coating device 1 when the coating liquid is supplied to the substrate W.

As shown in Fig. 11, the pre-wet nozzle 31 is arranged at the pre-wet position with the outer peripheral cup arranged at the cup upper position and with the substrate W rotating. At this time, the pre-wet nozzle 31 is maintained being directed downwardly toward the substrate W. The pre-wet position is, in detail, a position above the center of the substrate W held by the holder 11. Further, a predetermined amount of solvent is discharged from the pre-wet nozzle 31 to the upper surface of the rotating substrate W (pre-wetting). When the entire upper surface of the substrate W is wetted with the solvent, the pre-wet nozzle 31 moves to the waiting position.

Next, as shown in Fig. 12, the coating liquid nozzle 21 is arranged at the coating position. Further, the coating liquid is discharged from the coating liquid nozzle 21 to the upper surface of the rotating substrate W. The coating liquid spreads on the upper surface of the substrate W, so that a coating film is formed on the entire upper surface of the substrate W.

The processing liquid (the coating liquid and the solvent) splashing outwardly of the substrate W when the solvent is supplied to the substrate W and when the coating liquid is supplied to the substrate W is received by the inner peripheral surface 110 of the upper cup 100 and guided to the liquid collection groove 230 of the lower cup 200. Further, the processing liquid (the coating liquid and the solvent) falling from the outer peripheral end of the substrate W when the solvent is supplied to the substrate W and when the coating liquid is supplied to the substrate W is received by the upper surface 351 of the center cup 300 and guided to the liquid collection groove 230 of the lower cup 200. In this manner, the processing liquid is collected in the liquid collection groove 230. The collected processing liquid is further guided to the drain system through the drain hole 231 (Fig. 4) and the drain pipe connection portion 232.

In a chamber (not shown) of the coating device 1, a downward airflow in which clean air flows from above to below is formed. Therefore, when the solvent and the coating liquid are supplied to the substrate W, air flows into the gap between the substrate W and the upper cup 100. At this time, when an airflow around the substrate W is disturbed, liquid droplets of the processing liquid splashing or falling from the substrate W may splash in the chamber, and the cleanliness of the coating device 1 may be significantly degraded.

In contrast, the center cup main body 350 of the center cup 300 is formed to guide the air flowing into the gap between the substrate W and the upper cup 100 to the entire inner space of the liquid collection groove 230 through the gap between the center cup main body 350 of the center cup 300 and the outer peripheral cup. The air guided to the liquid collection groove 230 is smoothly guided to the entire inner space of the gas flow groove 220 through the space formed by the lower surface of the center cup main body 350. The air guided to the gas flow groove 220 is further guided to the exhaust system through the plurality of exhaust holes 221 (Fig. 4) and the exhaust pipe connection portion 222.

In this manner, with the center cup main body 350 and the lower cup 200, it is possible to collect the processing liquid splashing or falling from the substrate W during the process for the substrate W using the processing liquid. Further, a flow of gas in the peripheral portion of the substrate W can be regulated. Further, the processing liquid and air flowing below the substrate W can be guided to the drain system and the exhaust system while being separated from each other (gas-liquid separation).

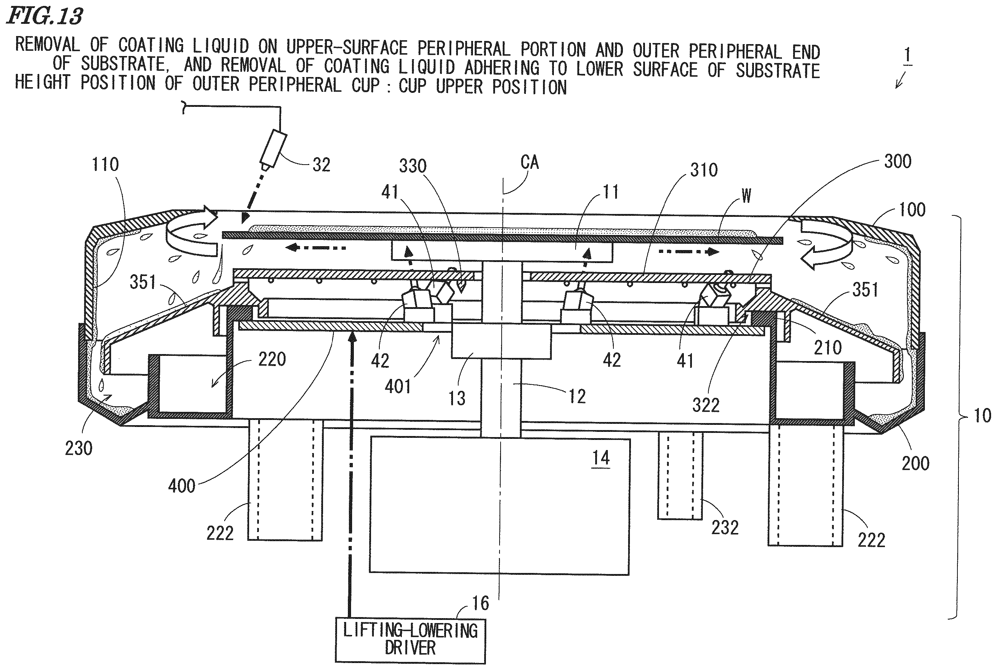

After the coating film is formed on the entire upper surface of the substrate W, the supply of the coating liquid from the coating liquid nozzle 21 to the substrate W is stopped, and the coating liquid nozzle 21 moves to the waiting position. Thereafter, as described above, the first solvent nozzle 32 is arranged at the peripheral-portion processing position. The peripheral-portion processing position is, in detail, a position above one portion of the outer peripheral end of the substrate W held by the holder 11. Further, the solvent is discharged from the first solvent nozzle 32 to the upper-surface peripheral portion of the rotating substrate W. Further, the solvent is discharged from the plurality of third solvent nozzles 42 to portions of the lower surface of the substrate W (back rinsing). Thus, the portions of the coating film on the upper-surface peripheral portion and the outer peripheral end of the substrate W are removed by the solvent. Further, in a case in which the coating liquid is adhering to the lower-surface peripheral portion of the substrate W, the coating liquid adhering to the lower surface of the substrate W is removed by the solvent. Fig. 13 shows the state of the coating device 1 when the coating film on the upper-surface peripheral portion and the outer peripheral end of the substrate W is removed and the coating liquid adhering to the lower surface of the substrate W is removed.

Here, the coating liquid that splashes or falls from the substrate W, and adheres to the upper surface 351 of the center cup 300 when the coating film is formed on the substrate W is likely to remain as solid matter on the upper surface 351 depending on a viscosity, a temperature and the like of the coating liquid.

In contrast, as described above, when the coating film on the upper-surface peripheral portion of the substrate W is removed, part of the solvent supplied to the upper-surface peripheral portion of the substrate W falls from a partial area in the circumferential direction of the outer peripheral end of the substrate W and flows downwardly along a partial area of the upper surface 351 of the center cup 300. At this time, a relatively large amount of solvent flows to the partial area of the upper surface 351 of the center cup 300. Thus, solid matter of the coating liquid remaining in the partial area of the upper surface 351 of the center cup 300 is dissolved and flows below the center cup 300. That is, the partial area of the upper surface 351 of the center cup 300 is cleaned.

After the portions of the coating film on the upper-surface peripheral portion and the outer peripheral end of the substrate W are removed and the back rinsing is performed, discharge of the solvent from each of the nozzles (32, 42) to the substrate W is stopped. Further, the first solvent nozzle 32 moves to the waiting position. The rotation of the substrate W is maintained in this state for a certain period of time, so that the substrate W is dried by spinning (spin drying).

After the substrate W is dried, the rotation driver 14 adjusts the rotation position (rotation angle: the orientation (posture) of the substrate W in the circumferential direction in the present example) of the substrate W after spin drying such that the rotation position of the substrate W coincides with the rotation position of the substrate W after the rotation of the center cup 300 by the prescribed angle α and before the start of rotation for pre-wetting. Thereafter, the work of the rotation driver 14 is stopped, and the rotation of the substrate W is stopped.

Here, in the above-mentioned stop state, the rotation position of the substrate W held by the holder 11 deviates by a prescribed angle α in the counterclockwise direction in plan view from the rotation position of the substrate W when the substrate W is carried into the coating device 1. It is not preferable that the rotation position of the substrate W carried into the coating device 1 is different from the rotation position of the substrate W carried out of the coating device 1.

As such, in the present embodiment, as described above, immediately after the temporary stop of the rotation of the substrate W after spin drying, the rotation driver 14 rotates the rotation shaft 12 clockwise (rightwardly) by the prescribed angle α in plan view and then stops the rotation shaft 12. Thus, the rotation position of the substrate W coincides with the rotation position of the substrate W when the substrate W is carried into the coating device 1.

Thereafter, the outer peripheral cup is lowered to the cup lower position by the lifting-lowering driver 16. Further, the state of the substrate W being held by suction by the holder 11 is released. Thus, the coating device 1 returns to the waiting state of Fig. 7. The substrate W on the holder 11 is carried out from the coating device 1.

### 4. Work of Coating Device 1 in Cup Cleaning Process

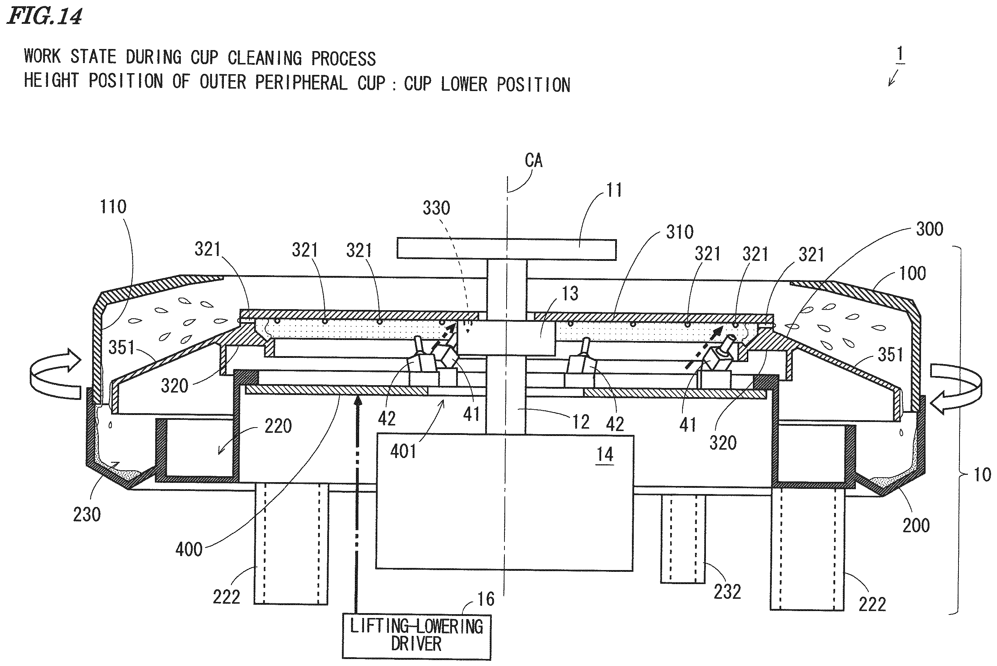

In the above-mentioned coating device 1, the inner surface of the outer peripheral cup and the upper surface 351 of the center cup 300 can be cleaned (hereinafter referred to as a cup cleaning process) using the solvent by the cup cleaning portion 310 and the plurality of second solvent nozzles 41. Fig. 14 is a schematic longitudinal cross-sectional view for explaining the work in the coating device 1 in the cup cleaning process.

In the cup cleaning process, as shown in Fig. 14, the outer peripheral cup is arranged at the cup lower position. Further, as described above, the center cup 300 is supported by the upper end surface of the cylindrical member 13 while the downward projection 330 of the center cup 300 is inserted into any one of the plurality of vertical holes 13b (Fig. 3) of the cylindrical member 13. At this time, the plurality of second solvent nozzles 41 on the base member 400 are respectively opposite to a plurality of portions of the cleaning peripheral wall 320 of the center cup 300. More specifically, the solvent discharge portion of each second solvent nozzle 41 is opposite to a partial area in the circumferential direction of the inner peripheral surface of the cleaning peripheral wall 320.

When the cup cleaning process is started, the rotation driver 14 works. Therefore, the center cup 300 rotates together with the rotation shaft 12. Further, the solvent is discharged from the plurality of second solvent nozzles 41 to the plurality of portions of the inner peripheral surface of the cleaning peripheral wall 320. The solvent discharged to the inside of the cleaning peripheral wall 320 is injected outwardly of the cup cleaning portion 310 through the plurality of injection ports 321 by a centrifugal force generated inside of the cleaning peripheral wall 320. The solvent injected from the plurality of injection ports 321 is received by the inner peripheral surface 110 of the upper cup 100 and the upper surface 351 of the center cup 300, so that the inner peripheral surface 110 and the upper surface 351 are cleaned. Further, the inner surface of the gas flow groove 220 is also cleaned.

In the cup cleaning process of the present example, the rotation shaft 12 and the center cup 300 rotate clockwise (rightwardly) in plan view. However, in the cup cleaning process, the rotation shaft 12 and the center cup 300 may rotate counterclockwise (leftwardly) in plan view. As described above, the cup cleaning process is executed with the outer peripheral cup arranged at the cup lower position. Therefore, the cup cleaning process cannot be executed in parallel with the process of forming a coating film on the substrate W.

### 5. Control System of Coating Device 1

A control system of the coating device 1 will be described together with the configuration of the controller 900 of Fig. 1. Fig. 15 is a block diagram showing the configuration of the control system of the coating device 1 of Fig. 1. As shown in Fig. 15, the controller 900 includes a CPU (Central Processing Unit) 901, a RAM (Random Access Memory) 902, a ROM (Read Only Memory) 903 and a storage device 904. The RAM 902 is used as a work area for the CPU 901. A system program is stored in the ROM 903. The storage device 904 includes a storage medium such as a hard disc or a semiconductor memory, and stores a coating processing program and a cup cleaning program. The coating processing program of the present example is a program for executing a process (a series of processes of Figs. 7 to 13) of forming a coating film on the upper surface of the substrate W except for the upper-surface peripheral portion. Further, the cup cleaning program is a program for executing the above-mentioned cup cleaning process.

Here, each of the coating processing program and the cup cleaning program of Fig. 15 may be provided in the state of being stored in a recording medium such as a CD-ROM 909, and may be installed in the ROM 903 or the storage device 904. Alternatively, each of the coating processing program and the cup cleaning program may be distributed from a server outside of the coating device 1 via a communication network, and may be installed in the ROM 903 or the storage device 904. The CPU 901 executes the coating processing program and the cup cleaning program, so that the work of each component of the coating device 1 is controlled.

A rotary encoder 19 is provided in the rotation driver 14. The rotary encoder 19 detects an amount of rotation of a rotor (not shown) of the rotation driver 14 and outputs a signal indicating the amount of rotation. The controller 900 controls the rotation driver 14 based on the signal output from the rotary encoder 19. Thus, the holder 11 rotates at a predetermined speed according to the processing contents for the substrate W. Further, the rotation positions (rotation angles) of the holder 11 and the rotation shaft 12 are adjusted.

Further, the controller 900 controls the coating liquid nozzle movement device 22. Thus, the coating liquid nozzle 21 of Fig. 1 moves between the coating position in the chamber and the waiting position. Further, the controller 900 controls the coating liquid supply system 20. Thus, the processing liquid is supplied to the coating liquid nozzle 21.

Further, the controller 900 controls the solvent nozzle movement device 33. The solvent nozzle movement device 33 may include a turning arm and an arm driver that rotates the turning arm, for example. In this case, the pre-wet nozzle 31 and the first solvent nozzle 32 of Fig. 1 are attached to the tip portion of the turning arm. Thus, the pre-wet nozzle 31 of Fig. 1 moves between the pre-wet position in the chamber and the waiting position so as to draw an arc in plan view, and the first solvent nozzle 32 of Fig. 1 moves between the peripheral-portion processing position in the chamber and the waiting position so as to draw an arc in plan view. Further, the controller 900 controls the solvent supply system 30. Thus, the solvent is supplied to each of the first solvent nozzle 32, the plurality of second solvent nozzles 41 of Fig. 1, and the plurality of third solvent nozzles 42 of Fig. 1.

Further, the controller 900 controls the suction device 15. Thus, the controller 900 switches the state of the holder 11 between a holding state in which the substrate W is held by suction and a release state in which the substrate W is not sucked. Further, the controller 900 controls the lifting-lowering driver 16. Thus, the height position of the outer peripheral cup is adjusted in the range from the cup lower position to the cup upper position.

As shown in Fig. 15, the coating device 1 further includes an operation unit 910. The operation unit 910 includes a keyboard and a pointing device, and is configured to be operable by a user. The user can set various work conditions of the coating device 1 by operating the operation unit 910.

The various work conditions of the coating device 1 include the above-mentioned prescribed angle α, an amount of the coating liquid to be supplied to the substrate W, a rotation speed of the substrate W at the time of supply of the coating liquid, a rotation speed of the substrate W at the time of spin drying, and a start point in time of the cup cleaning process, for example.

### 6. Effects

(a) In the above-mentioned coating device 1, each time an unprocessed substrate W is carried in, a coating film is formed on the entire upper surface of the substrate W, and part of the coating film formed on the upper-surface peripheral portion of the substrate W is removed.

When the coating film formed on the upper-surface peripheral portion of the substrate W is removed, the solvent is supplied from the first solvent nozzle 32 arranged at the peripheral-portion processing position to a partial area in the circumferential direction of the upper-surface peripheral portion of the rotating substrate W. Thus, of the coating film on the substrate W, a portion of the coating film formed on the upper-surface peripheral portion of the substrate W is removed. In this case, part of the solvent supplied to the substrate W falls from the partial area in the circumferential direction of the outer peripheral end of the substrate W and flows downwardly along part of the upper surface 351 of the center cup 300. Thus, solid matter of the coating liquid remaining in a partial area of the upper surface of the center cup is dissolved by the solvent, and the partial area is washed away.

Further, in the above-mentioned coating device 1, the center cup 300 rotates by the prescribed angle α with respect to the reference axis CA each time the process of forming a coating film on one substrate W is executed. In this case, a plurality of partial areas in the circumferential direction of the upper surface 351 of the center cup 300 are sequentially arranged at a position at which the solvent used for removing the coating film on the upper-surface peripheral portion of the substrate W falls, and are cleaned. Thus, the solvent used for removing coating films on the upper-surface peripheral portions of a plurality of substrates W can be used for cleaning the entire periphery of the upper surface 351 of the center cup 300. Therefore, it is not necessary to increase the number of times of maintenance in order to clean the center cup 300.

As a result, it is possible to improve the cleanliness of the cup while suppressing a reduction in work efficiency of the coating device 1 and suppressing an increase in consumption of the solvent used for cleaning the cup.

(b) The solvent used for removing the coating film on the upper-surface peripheral portion of the substrate W is referred to as a partial removal solvent. In this case, in a case in which a partial area of the upper surface 351 of the center cup 300 is cleaned with the partial removal solvent falling from the substrate W, the prescribed angle α is preferably set in consideration of an angular range of the partial area with respect to the reference axis CA. For example, when the partial removal solvent is supplied to one substrate W, in a case in which the angular range of the partial area of the upper surface 351 to be cleaned by the partial removal solvent falling from the substrate W is β°, the prescribed angle α is set to an angle smaller than β°. Thus, the partial area of the upper surface 351 of the center cup 300 to be cleaned by execution of the coating process on one substrate W partially overlaps the partial area of the upper surface 351 of the center cup 300 that has been cleaned during the previous coating process on a substrate W. Therefore, the entire upper surface 351 of the center cup 300 can be thoroughly cleaned.

(c) In the above-mentioned coating device 1, the rotation driver 14 rotates the substrate W via the rotation shaft 12 and the holder 11. Further, in the above-mentioned coating device 1, the center cup 300 includes the cup cleaning portion 310 and the center cup main body 350 which are integrally molded. The rotation driver 14 rotates the center cup main body 350 via the rotation shaft 12, the cylindrical member 13 and the cup cleaning portion 310. In this manner, the rotation driver 14 is used as a driver for rotating the substrate W and a driver for rotating the center cup main body 350. Thus, it is not necessary to separately provide a driver for rotating the substrate W and a driver for rotating the center cup main body 350. This suppresses an increase in number of components of the coating device 1 and an increase in cost of the coating device 1.

(d) In the above-mentioned coating device 1, the rotation driver 14 rotates the rotation shaft 12 clockwise (rightwardly) in plan view when a coating film is removed from the upper-surface peripheral portion of the substrate W. That is, the substrate W is rotated clockwise in plan view. On the other hand, the rotation driver 14 rotates the center cup 300 counterclockwise (leftwardly) in plan view each time the substrate W is placed on the holder 11. The reason will be described.

For example, in a case in which being supplied to the upper-surface peripheral portion of the substrate W that is rotating clockwise, a solvent falling from a partial area in the circumferential direction of the outer peripheral end of the substrate W flows clockwise in plan view. Therefore, on the upper surface 351 of the center cup main body 350, solid matter of the coating liquid to be removed flows clockwise while being dissolved by the solvent. When the center cup 300 rotates clockwise by the prescribed angle α each time a new substrate W is held by the holder 11, a partial area of the upper surface 351 that is cleaned after one rotation work is to be contaminated by cleaning for another partial area of the upper surface 351 after the next rotation work.

As described above, each time the substrate W is placed on the holder 11, the rotation driver 14 rotates the center cup 300 by the prescribed angle α in the rotation direction (counterclockwise direction) opposite to the rotation direction (clockwise direction) of the substrate W during supply of the solvent to the substrate W. In this case, the partial area of the upper surface 351 of the center cup 300 that is cleaned after one rotation work is not to be contaminated by cleaning for another partial area of the upper surface 351 of the center cup 300 after the next rotation work. Therefore, the cleanliness of the center cup 300 is improved.

### 7. Inventive Example and Comparative Example

The inventors of the present disclosure have used the coating device 1 having the configuration of Fig. 1 as a coating device of an inventive example, and have sequentially executed a coating process on 18 substrates W using the coating device. Further, as a coating device of a comparative example, the inventors of the present disclosure used a coating device having the same configuration as that of the coating device of the inventive example except that the cup cleaning portion 310 and the center cup main body 350 were separated from each other. In the coating device of the comparative example, a center cup main body 350 was integrally provided as a center cup in an outer peripheral cup. Then, the inventors of the present disclosure sequentially executed a coating process on 18 substrates W using the coating device of the comparative example.

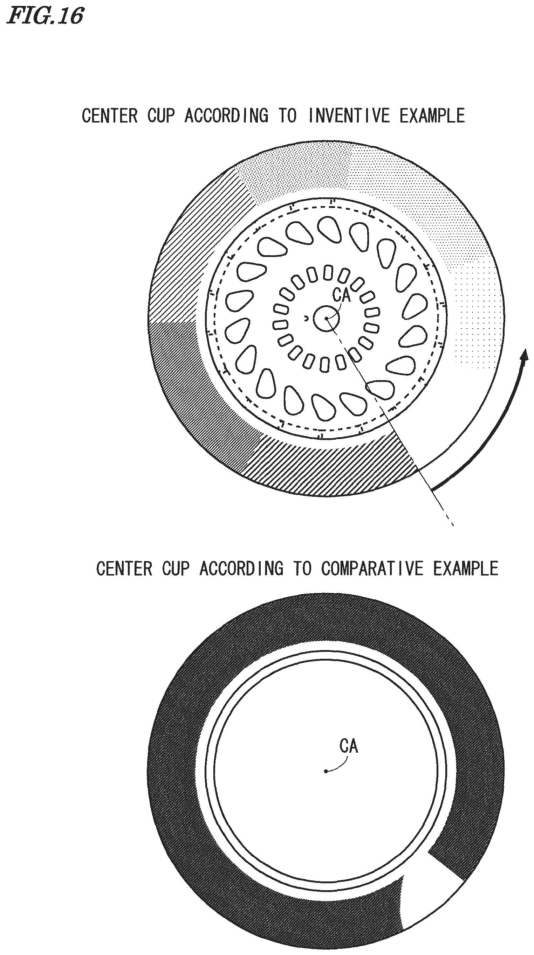

Thereafter, the inventors of the present disclosure compared a contamination state of a center cup according to the inventive example with the contamination state of the center cup according to the comparative example. Fig. 16 is a diagram schematically showing a result of comparison between a contamination state of a center cup according to an inventive example and a contamination state of a center cup according to a comparative example. In the upper field of Fig. 16, the contamination state of the center cup according to the inventive example is shown in a plan view. In the lower field of Fig. 16, the contamination state of the center cup according to the comparative example is shown in a plan view.

In each plan view, the contamination state in the center cup is indicated by hatchings and dotted patterns. Further, in each plan view, the higher the density of a hatching or a dotted pattern, the higher the degree of contamination, and the lower the density of a hatching or a dotted pattern, the lower the degree of contamination.

As shown in the upper field of Fig. 16, in the center cup according to the inventive example, an entire annular upper surface portion that receives a processing liquid falling from the substrate W is contaminated, except for an area in a partial angular range. The farther the counterclockwise in a circumferential direction a portion in the upper surface portion of the center cup with respect to a predetermined angular position, the higher the degree of contamination. On the other hand, as shown in the lower field of Fig. 16, in the center cup according to the comparative example, an entire annular upper surface portion that receives a processing liquid falling from the substrate W is contaminated, except for an area in a partial angular range. The degree of contamination is substantially uniform except for the area in the partial angular range.

When the degree of contamination of the center cup according to the inventive example is compared to the degree of contamination of the center cup according to the comparative example, the degree of contamination of the center cup according to the comparative example is significantly higher than the degree of contamination of the center cup according to the inventive example. As a result, it was confirmed that, with the coating device of the inventive example, even when a cup cleaning process is not frequently executed, it is possible to maintain higher cleanliness than that of the center cup of the coating device of the comparative example.

### 8. Other Embodiments

(a) While the center cup 300 according to the above-mentioned embodiment is an integrally molded product including the cup cleaning portion 310 and the center cup main body 350, the present disclosure is not limited to this. The center cup 300 may be fabricated by connection of the cup cleaning portion 310 and the center cup main body 350, which are individually fabricated, to each other.
(b) In the coating device 1 according to the above-mentioned embodiment, the state of connection between the center cup 300 and the cylindrical member 13 is changed by adjustment of the height position of the center cup 300. Thus, the rotation driver 14 that rotates the substrate W is used as a rotation driver that rotates the center cup 300. The present disclosure is not limited to this. The coating device 1 may have another rotation driver that rotates the center cup 300 by the prescribed angle α with respect to the outer peripheral cup, in addition to the rotation driver 14.
(c) While the center cup 300 according to the above-mentioned embodiment is an integrally molded product including the cup cleaning portion 310 and the center cup main body 350, the present disclosure is not limited to this. The cup cleaning portion 310 and the center cup main body 350 of the center cup 300 may be provided in the coating device 1 while being separated from each other. In this case, the coating device 1 is required to have, in addition to the rotation driver 14, another rotation driver that rotates the center cup main body 350 by the prescribed angle α with respect to the outer peripheral cup.
(d) While the center cup 300 is rotated by the prescribed angle α with respect to the outer peripheral cup immediately after the substrate W is carried in and held by suction on the holder 11 in the coating device 1 according to the above-mentioned embodiment, the present disclosure is not limited to this. The center cup 300 may rotate by the prescribed angle α with respect to the outer peripheral cup each time a new substrate W is placed on the holder 11. Therefore, the center cup 300 may be rotated by the prescribed angle α with respect to the outer peripheral cup immediately before one substrate W is carried out from the holder 11.
(e) The rotation driver 14 according to the above-mentioned embodiment rotates the rotation shaft 12 clockwise in plan view when a coating film is removed from the upper-surface peripheral portion of the substrate W. Further, the rotation driver 14 rotates the center cup 300 counterclockwise in plan view each time the substrate W is placed on the holder 11. However, the present disclosure is not limited to this.

The rotation driver 14 may rotate the rotation shaft 12 counterclockwise in plan view when a coating film is removed from the upper-surface peripheral portion of the substrate W, and may rotate the center cup 300 clockwise in plan view each time the substrate W is placed on the holder 11.

The direction in which the substrate W rotates when a coating film is removed from the upper-surface peripheral portion of the substrate W may coincide with the direction in which the center cup 300 rotates each time the substrate W is placed on the holder 11.

(f) While the center cup 300 rotates by the prescribed angle α with respect to the reference axis CA each time an unprocessed substrate W is carried into the coating device 1 according to the above-mentioned embodiment, the present disclosure is not limited to this. The center cup 300 may rotate by the prescribed angle α with respect to the reference axis CA each time a predetermined number (two or three, for example) of substrates W are sequentially processed in the coating device 1. Alternatively, the center cup 300 may rotate by the prescribed angle α with respect to the reference axis CA each time a predetermined period of time elapses after the coating device 1 is powered on.

### 9. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the coating device 1 is an example of a coating device, the reference axis CA is an example of a reference axis, the configuration including the holder 11, the rotation shaft 12 and the rotation driver 14 is an example of a rotation holder, the outer peripheral cup including the upper cup 100 and the lower cup 200 is an example of an outer peripheral cup, the center cup main body 350 of the center cup 300 is an example of a center cup, and the peripheral-portion processing position is an example of a first position.

Further, the first solvent nozzle 32 is an example of a first solvent nozzle, the configuration including the rotation driver 14, the rotation shaft 12, the cylindrical member 13 and the cup cleaning portion 310 of the center cup 300 is an example of a cup rotation driver, the holder 11 is an example of a holder, the rotation shaft 12 is an example of a rotation shaft, the rotation driver 14 is an example of a substrate rotation driver, the upper surface 351 of the center cup main body 350 is an example of an upper surface, and the cup cleaning portion 310 of the center cup 300 is an example of a cup cleaning member.

Further, the second solvent nozzle 41 is an example of a second solvent nozzle, the cleaning peripheral wall 320 of the cup cleaning portion 310 is an example of a peripheral wall, the plurality of injection ports 321 formed in the cleaning peripheral wall 320 are an example of a plurality of solvent injection ports, and the position at which the second solvent nozzle 41 is installed on the base member 400 is an example of a second position.

Further, the base member 400 is an example of a base member, the plurality of first through holes 311 formed in the center cup 300 are an example of a plurality of first through holes, the third solvent nozzle 42 is an example of a third solvent nozzle, the plurality of second through holes 312 formed in the center cup 300 are an example of a plurality of second through holes, and the position at which the third solvent nozzle 42 is installed on the base member 400 is an example of a third position.

Further, the cylindrical member 13 is an example of a cylindrical member, the lifting-lowering driver 16, the base member 400 and the lower cup 200 are examples of a first lifter-lowerer, the plurality of vertical holes 13b of the cylindrical member 13 are an example of a plurality of engaging portions, the downward projection 330 of the center cup 300 is an example of one or a plurality of engaged portions, and the lifting-lowering driver 16 and the base member 400 are examples of a second lifter-lowerer.

### 10. Overview of Embodiments

(Item 1) A coating device according to item 1 that forms a coating film on a substrate by supplying a coating liquid to an upper surface of the substrate, with the substrate being at least partially circular, includes a rotation holder that holds the substrate and rotates the held substrate about a reference axis extending in an upward-and-downward direction, an outer peripheral cup provided around the substrate held by the rotation holder, a center cup arranged inwardly of the outer peripheral cup and below the substrate held by the rotation holder, a first solvent nozzle that supplies a solvent to a partial area in a circumferential direction of an upper-surface peripheral portion of the substrate rotated by the rotation holder from a predetermined first position above the substrate held by the rotation holder, and a cup rotation driver that rotates the center cup about the reference axis.

In the coating device, the outer peripheral cup includes an upper cup and a lower cup, for example. The upper cup is provided so as to surround the rotation holder in plan view. The lower cup has a liquid collector connected to the drain system and surrounding the rotation holder in plan view, and is provided below the upper cup. Further, the center cup is annular, surrounds the rotation holder in plan view, and is provided at a position below the upper end of the upper cup and above the liquid collector of the lower cup.

The coating liquid is supplied to the upper surface of the substrate held by the rotation holder, so that a coating film is formed on the entire upper surface of the substrate. At this time, part of the coating liquid supplied to the upper surface of the substrate splashes sidewardly of the substrate. The upper cup has an inner peripheral surface opposite to the outer peripheral end of the substrate during supply of the coating liquid to the substrate. Thus, the coating liquid splashing from the substrate is received by the upper cup. The received coating liquid flows downwardly along the inner surface of the upper cup and is collected by the liquid collector of the lower cup.

Further, when the coating liquid is supplied to the substrate, part of the remaining coating liquid supplied to the upper surface of the substrate falls from the outer peripheral end of the substrate. The center cup has an inner diameter smaller than the substrate and an outer diameter larger than the substrate in plan view. Thus, the coating liquid falling from the outer peripheral end of the substrate is received by the center cup. Further, the center cup has a cylindrical shape such that its diameter gradually increases from above to below similarly to the outer peripheral surface of a truncated cone. That is, the upper surface of the center cup is formed so as to extend obliquely downwardly from an upper end portion to a lower end portion in a direction away from the reference axis. Therefore, the received coating liquid flows downwardly along the upper surface of the center cup and is collected by the liquid collector of the lower cup.

In this manner, the coating liquid splashing or falling from the substrate when the coating liquid is supplied to the substrate is collected in the liquid collector of the lower cup. The collected coating liquid is guided to a drain system and discharged from the coating device.

After the coating film is formed on the entire upper surface of the substrate, the solvent is supplied from the first position to a partial area in the circumferential direction of the upper-surface peripheral portion of the rotating substrate. Thus, of the coating film on the substrate, a portion of the coating film formed on the upper-surface peripheral portion of the substrate is removed. In this case, part of the solvent supplied to the substrate falls from a partial area in the circumferential direction of the outer peripheral end of the substrate and flows downwardly along part of the upper surface of the center cup.

Depending on a viscosity, a temperature and the like of the coating liquid to be supplied to the substrate, solid matter of the coating liquid remains on the upper surface of the center cup after the coating liquid is supplied to the substrate. In contrast, when the solvent is supplied to the upper-surface peripheral portion of the substrate, the solvent falling from the partial area in the circumferential direction of the outer peripheral end of the substrate is received by a partial area in the circumferential direction of the upper surface of the center cup. At this time, the solvent dissolves solid matter of the coating liquid remaining in the partial area of the upper surface of the center cup, and washes away the partial area.

The cup rotation driver is configured to be capable of rotating the center cup about the reference axis. In this case, the center cup can be rotated by a predetermined angle such that the positional relationship between each portion of the center cup and the first position relatively changes each time a coating film is formed on the substrate and each time a coating film is removed from the upper-surface peripheral portion of the substrate. Thus, a solvent can be sequentially supplied to a plurality of partial areas in the circumferential direction of the upper surface of the center cup. That is, the solvent used to remove a coating film on the upper-surface peripheral portion of the substrate can be used to clean the center cup. Further, it is not necessary to increase the number of times of maintenance in order to clean the center cup.

As a result, it is possible to improve the cleanliness of the cup while suppressing degradation of work efficiency of the coating device and suppressing an increase in consumption of the solvent used to clean the cup.

(Item 2) The coating device according to item 1, wherein the cup rotation driver may rotate the center cup about the reference axis by a prescribed angle that is larger than 0° and smaller than 360° each time a new substrate is held by the rotation holder.

In this case, a new substrate is repeatedly held by the rotation holder, so that a plurality of partial areas in the circumferential direction of the upper surface of the center cup are sequentially arranged at a position at which the solvent used to remove the coating film of the upper-surface peripheral portion of the substrate falls, to be cleaned.

(Item 3) The coating device according to item 1 or 2, wherein the rotation holder may include a holder that holds the substrate, a rotation shaft provided to extend along the reference axis and connected to the holder from below, and a substrate rotation driver that drives the rotation shaft, and the cup rotation driver may be the substrate rotation driver.

In this case, it is not necessary to separately provide the substrate rotation driver and the cup rotation driver. This suppresses an increase in number of components of the coating device and an increase in cost of the coating device.

(Item 4) The coating device according to item 2, wherein the rotation holder may include a holder that holds the substrate, a rotation shaft provided to extend along the reference axis and connected to the holder from below, and a substrate rotation driver that drives the rotation shaft, the center cup may have an upper surface that is annular in plan view, and is formed to extend obliquely downwardly and in a direction away from the reference axis from an upper end portion to a lower end portion of the center cup, the coating device may further include a cup cleaning member that is circular in plan view and configured to be attachable to and detachable from the rotation shaft, and a second solvent nozzle provided inwardly of the center cup in plan view, the cup cleaning member may have a peripheral wall extending in the upward-and-downward direction at an outer peripheral end of the cup cleaning member, a plurality of solvent injection ports may be formed in a plurality of portions in a circumferential direction in the peripheral wall, the second solvent nozzle may supply a solvent to a partial area in a circumferential direction in an inner peripheral surface of the peripheral wall from a predetermined second position below the cup cleaning member, and the peripheral wall of the cup cleaning member may be integrally connected to the upper end portion of the center cup.

In the coating device, the coating liquid adheres to each of the upper cup, the lower cup and the center cup each time the process of forming a coating film on a substrate is executed. When solid matter of the coating liquid cumulatively remains in each cup, the cleanliness of the cup is significantly degraded.

As such, a cup cleaning member is connected to the rotation shaft each time a certain number of substrates are processed. Further, the solvent is supplied from the second solvent nozzle to the cup cleaning member while the rotation shaft is rotated. In this case, the solvent is injected from the plurality of solvent injection ports of the cup cleaning member to the inner peripheral surface of the upper cup and the upper surface of the center cup. Further, the solvent flowing on the inner peripheral surface of the upper cup and the upper surface of the center cup flows to the liquid collector of the lower cup. Thus, solid matter of the coating liquid adhering to the inner peripheral surface of the upper cup, the upper surface of the center cup, and the surface of the liquid collector of the lower cup is removed.

Here, the cup cleaning member is attachable to and detachable from the rotation shaft. Further, the cup cleaning member and the center cup are integrally connected. Therefore, with the cup cleaning member connected to the rotation shaft, the center cup rotates together with the cup cleaning member when the rotation shaft rotates. Therefore, with the above-mentioned configuration, the substrate rotation driver can also serve as the cup rotation driver. This suppresses an increase in number of components of the coating device and an increase in cost of the coating device.

(Item 5) The coating device according to item 4, may further include a base member provided at a position below the cup cleaning member to be movable in the upward-and-downward direction, wherein the second solvent nozzle may be supported on an upper surface of the base member, in the cup cleaning member, a plurality of first through holes into which the second solvent nozzle is insertable may be formed at intervals of the prescribed angle about the reference axis, and the cup cleaning member and the second solvent nozzle may be arranged such that, each time the center cup rotates by the prescribed angle, the second solvent nozzle overlaps with any one of the plurality of first through holes in plan view.

In this case, in a case in which the base member is close to the cup cleaning member, the interference between the second solvent nozzle and the cup cleaning member is prevented.

(Item 6) The coating device according to item 5, may further include a third solvent nozzle supported on an upper surface of the base member and provided inwardly of the center cup in plan view, wherein in the cup cleaning member, a plurality of second through holes into which the third solvent nozzle may be insertable are formed at intervals of the prescribed angle about the reference axis, the cup cleaning member and the third solvent nozzle may be arranged such that, each time the center cup rotates by the prescribed angle, the third solvent nozzle overlaps with any one of the plurality of second through holes in plan view, and the third solvent nozzle, while being inserted into any one of the plurality of second through holes, may supply a solvent to an area except for a lower-surface center portion of the substrate from a predetermined third position below the substrate held by the rotation holder.

In this case, in a case in which the base member is close to the cup cleaning member, the interference between the third solvent nozzle and the cup cleaning member is prevented. Further, the solvent can be supplied to the lower-surface peripheral portion of the substrate with the third solvent nozzle inserted into one second through hole. That is, a back rinse process after a coating film is formed on the substrate can be executed.

(Item 7) The coating device according to any one of items 4 to 6, may further include a cylindrical member that is provided to surround part of the rotation shaft at a position below the holder and is fixed to the rotation shaft, and a first lifter-lowerer that moves the center cup and the cup cleaning member in the upward-and-downward direction at a position above the cylindrical member, wherein the cylindrical member and the cup cleaning member may be arranged to at least partially overlap with each other, and may be arranged such that an upper surface of the cylindrical member and a lower surface of the cup cleaning member face each other, in one of the upper surface of the cylindrical member and the lower surface of the cup cleaning member, a plurality of engaging portions may be formed at intervals of the prescribed angle about the reference axis, and in another one of the upper surface of the cylindrical member and the lower surface of the cup cleaning member, one or a plurality of engaged portions that are engageable with the plurality of engaging portions and separable from the plurality of engaging portions by movement of the cup cleaning member in the upward-and-downward direction may be formed.

In this case, the cup cleaning member is moved in an upward-and-downward direction, and the plurality of engaging portions of the cylindrical member (or the cup cleaning member) are engaged with the one or plurality of engaged portions of the cup cleaning member (or the cylindrical member). In this state, the center cup can be rotated by the prescribed angle by rotation of the rotation shaft.

On the other hand, the cup cleaning member is moved in the upward-and-downward direction, and the plurality of engaging portions of the cylindrical member (or the cup cleaning member) are spaced apart from the one or plurality of engaged portions of the cup cleaning member (or the cylindrical member). The rotation shaft is rotated in this state, so that the substrate held by the holder can be rotated without rotation of the center cup.

(Item 8) The coating device according to item 7, may further include a second lifter-lowerer that moves the outer peripheral cup in the upward-and-downward direction, wherein at least part of the outer peripheral cup may form part of the first lifter-lowerer by supporting at least part of the cup cleaning member and the center cup from below in at least part of a lifting period in which the outer peripheral cup is lifted by the second lifter-lowerer and a lowering period in which the outer peripheral cup is lowered by the second lifter-lowerer.

In this case, when the coating liquid is supplied to the substrate, for example, the outer peripheral cup can be moved to a height position corresponding to the substrate held by the holder. Thus, the coating liquid splashing from the substrate is received by the outer peripheral cup. Further, when the substrate is received from or transferred to the holder, for example, the outer peripheral cup can be moved to a height position spaced apart from the holder. This prevents interference between a substrate transfer robot and the outer peripheral cup.

With the above-mentioned configuration, by movement of the outer peripheral cup in the upward-and-downward direction, at least part of the outer peripheral cup forms part of the first lifter-lowerer. In this case, it is not necessary to separately provide the first lifter-lowerer and the second lifter-lowerer. This suppresses an increase in number of components of the coating device and an increase in cost of the coating device.

(Item 9) The coating device according to any one of items 1 to 7, wherein the rotation holder may rotate the substrate in a first rotation direction when the coating liquid is supplied to the substrate, and a direction in which the cup rotation driver rotates the center cup may be a second rotation direction opposite to the first rotation direction.

In a case in which the solvent is supplied to the upper-surface peripheral portion of the substrate rotating in the first rotation direction, the solvent falling from the partial area in the circumferential direction of the outer peripheral end of the substrate flows in the first rotation direction in plan view. Therefore, on the upper surface of the center cup, solid matter of the coating liquid to be removed flows in the first rotation direction while being dissolved by the solvent. When the center cup rotates by the prescribed angle in the first rotation direction each time a new substrate is held by the rotation holder, a partial area of the upper surface of the center cup cleaned after one rotation work is contaminated by cleaning for another partial area of the upper surface of the center cup after the next rotation work.

With the above-mentioned configuration, the cup rotation driver rotates the center cup in the second rotation direction opposite to the first rotation direction. In this case, the partial area of the upper surface of the center cup cleaned after one rotation work is not contaminated by cleaning for another partial area of the upper surface of the center cup after the next rotation work. Therefore, the cleanliness of the center cup is improved.

(Item 10) A coating method according to item 10 is a method of forming a coating film on a substrate by using a coating device, with the substrate being at least partially circular, wherein the coating device further includes a rotation holder that holds the substrate and rotates the held substrate about a reference axis extending in an upward-and-downward direction, an outer peripheral cup provided around the substrate held by the rotation holder, a center cup arranged inwardly of the outer peripheral cup and below the substrate held by the rotation holder, and a first solvent nozzle that supplies a solvent to a partial area in a circumferential direction of an upper-surface peripheral portion of the substrate rotated by the rotation holder from a predetermined first position above the substrate held by the rotation holder, and the coating method includes a first step of forming the coating film on an entire upper surface of one substrate by supplying a coating liquid to an upper surface of the one substrate held and rotated by the rotation holder, a second step of supplying a solvent from the first solvent nozzle to a partial area in a circumferential direction of an upper-surface peripheral portion of the one substrate held and rotated by the rotation holder after the coating film is formed on the entire upper surface of the one substrate, and a third step of rotating the center cup about the reference axis after the first step and the second step are performed on the one substrate and until the first step and the second step are performed on a next substrate.

In the above-mentioned coating device, the outer peripheral cup includes an upper cup and a lower cup, for example. The upper cup is provided so as to surround the rotation holder in plan view. The lower cup has a liquid collector connected to the drain system and surrounding the rotation holder in plan view, and is provided below the upper cup. Further, the center cup is annular, surrounds the rotation holder in plan view, and is provided at a position below the upper end of the upper cup and above the liquid collector of the lower cup.

In the first step of the coating method, the coating liquid is supplied to the upper surface of the substrate held by the rotation holder, whereby a coating film is formed on the entire upper surface of the substrate. At this time, part of the coating liquid supplied to the upper surface of the substrate splashes sidewardly of the substrate. The upper cup has an inner peripheral surface opposite to the outer peripheral end of the substrate during supply of the coating liquid to the substrate. Thus, the coating liquid splashing from the substrate is received by the upper cup. The received coating liquid flows downwardly along the inner surface of the upper cup and is collected by the liquid collector of the lower cup.

Further, when the coating liquid is supplied to the substrate, part of the remaining coating liquid supplied to the upper surface of the substrate falls from the outer peripheral end of the substrate. The center cup has an inner diameter smaller than the substrate and an outer diameter larger than the substrate in plan view. Thus, the coating liquid falling from the outer peripheral end of the substrate is received by the center cup. Further, the center cup has a cylindrical shape such that its diameter gradually increases from above to below similarly to the outer peripheral surface of a truncated cone. That is, the upper surface of the center cup is formed so as to extend obliquely downwardly from an upper end portion to a lower end portion in a direction away from the reference axis. Therefore, the received coating liquid flows downwardly along the upper surface of the center cup and is collected by the liquid collector of the lower cup.

In this manner, the coating liquid splashing or falling from the substrate when the coating liquid is supplied to the substrate is collected in the liquid collector of the lower cup. The collected coating liquid is guided to a drain system and discharged from the coating device.

In the second step, the solvent is supplied from the first position to a partial area in the circumferential direction of the upper-surface peripheral portion of the rotating substrate. Thus, of the coating film on the substrate, a portion of the coating film formed on the upper-surface peripheral portion of the substrate W is removed. In this case, part of the solvent supplied to the substrate falls from a partial area in the circumferential direction of the outer peripheral end of the substrate and flows downwardly along part of the upper surface of the center cup.

Depending on a viscosity, a temperature and the like of the coating liquid to be supplied to the substrate, solid matter of the coating liquid remains on the upper surface of the center cup after the coating liquid is supplied to the substrate. In contrast, when the solvent is supplied to the upper-surface peripheral portion of the substrate, the solvent falling from the partial area in the circumferential direction of the outer peripheral end of the substrate is received by a partial area in the circumferential direction of the upper surface of the center cup. At this time, the solvent dissolves solid matter of the coating liquid remaining in the partial area of the upper surface of the center cup, and washes away the partial area.

In the third step, the center cup rotates about the reference axis in a period after the first step and the second step are performed on one substrate and before the first step and the second step are performed on the next substrate. In this case, each time the first step and the second step are performed on a plurality of substrates, the positional relationship between each portion of the center cup and the first position relatively changes. Thus, a solvent can be sequentially supplied to a plurality of partial areas in the circumferential direction of the upper surface of the center cup. That is, the solvent used to remove a coating film on the upper-surface peripheral portion of the substrate can be used to clean the center cup. Further, it is not necessary to increase the number of times of maintenance in order to clean the center cup.

As a result, it is possible to improve the cleanliness of the cup while suppressing degradation of work efficiency of the coating device and suppressing an increase in consumption of the solvent used to clean the cup.

While preferred embodiments of the present disclosure have been described above, it is to be understood that variations and modifications will be apparent to those skilled in the art without departing the scope and spirit of the present disclosure. The scope of the present disclosure, therefore, is to be determined solely by the following claims.

## Claims

1. A coating device that forms a coating film on a substrate by supplying a coating liquid to an upper surface of the substrate, the substrate being at least partially circular, comprising:
a rotation holder that holds the substrate and rotates the held substrate about a reference axis extending in an upward-and-downward direction;
an outer peripheral cup provided around the substrate held by the rotation holder;
a center cup arranged inwardly of the outer peripheral cup and below the substrate held by the rotation holder;
a first solvent nozzle that supplies a solvent to a partial area in a circumferential direction of an upper-surface peripheral portion of the substrate rotated by the rotation holder from a predetermined first position above the substrate held by the rotation holder; and
a cup rotation driver that rotates the center cup about the reference axis.

2. The coating device according to claim 1, wherein
the cup rotation driver rotates the center cup about the reference axis by a prescribed angle that is larger than 0° and smaller than 360° each time a new substrate is held by the rotation holder.

3. The coating device according to claim 1 or 2, wherein
the rotation holder includes
a holder that holds the substrate,
a rotation shaft provided to extend along the reference axis and connected to the holder from below, and
a substrate rotation driver that drives the rotation shaft, and
the cup rotation driver is the substrate rotation driver.

4. The coating device according to claim 2, wherein
the rotation holder includes
a holder that holds the substrate,
a rotation shaft provided to extend along the reference axis and connected to the holder from below, and
a substrate rotation driver that drives the rotation shaft,
the center cup has an upper surface that is annular in plan view, and is formed to extend obliquely downwardly and in a direction away from the reference axis from an upper end portion to a lower end portion of the center cup,
the coating device further includes
a cup cleaning member that is circular in plan view and configured to be attachable to and detachable from the rotation shaft, and
a second solvent nozzle provided inwardly of the center cup in plan view,
the cup cleaning member has a peripheral wall extending in the upward-and-downward direction at an outer peripheral end of the cup cleaning member,
a plurality of solvent injection ports are formed in a plurality of portions in a circumferential direction in the peripheral wall,
the second solvent nozzle supplies a solvent to a partial area in a circumferential direction in an inner peripheral surface of the peripheral wall from a predetermined second position below the cup cleaning member, and
the peripheral wall of the cup cleaning member is integrally connected to the upper end portion of the center cup.

5. The coating device according to claim 4, further comprising a base member provided at a position below the cup cleaning member to be movable in the upward-and-downward direction, wherein
the second solvent nozzle is supported on an upper surface of the base member,
in the cup cleaning member, a plurality of first through holes into which the second solvent nozzle is insertable are formed at intervals of the prescribed angle about the reference axis, and
the cup cleaning member and the second solvent nozzle are arranged such that, each time the center cup rotates by the prescribed angle, the second solvent nozzle overlaps with any one of the plurality of first through holes in plan view.

6. The coating device according to claim 5, further comprising a third solvent nozzle supported on an upper surface of the base member and provided inwardly of the center cup in plan view, wherein
in the cup cleaning member, a plurality of second through holes into which the third solvent nozzle is insertable are formed at intervals of the prescribed angle about the reference axis,
the cup cleaning member and the third solvent nozzle are arranged such that, each time the center cup rotates by the prescribed angle, the third solvent nozzle overlaps with any one of the plurality of second through holes in plan view, and
the third solvent nozzle, while being inserted into any one of the plurality of second through holes, supplies a solvent to an area except for a lower-surface center portion of the substrate from a predetermined third position below the substrate held by the rotation holder.

7. The coating device according to any one of claims 4 to 6, further comprising:
a cylindrical member that is provided to surround part of the rotation shaft at a position below the holder and is fixed to the rotation shaft; and
a first lifter-lowerer that moves the center cup and the cup cleaning member in the upward-and-downward direction at a position above the cylindrical member, wherein
the cylindrical member and the cup cleaning member are arranged to at least partially overlap with each other, and are arranged such that an upper surface of the cylindrical member and a lower surface of the cup cleaning member face each other,
in one of the upper surface of the cylindrical member and the lower surface of the cup cleaning member, a plurality of engaging portions are formed at intervals of the prescribed angle about the reference axis, and
in another one of the upper surface of the cylindrical member and the lower surface of the cup cleaning member, one or a plurality of engaged portions that are engageable with the plurality of engaging portions and separable from the plurality of engaging portions by movement of the cup cleaning member in the upward-and-downward direction are formed.

8. The coating device according to claim 7, further comprising a second lifter-lowerer that moves the outer peripheral cup in the upward-and-downward direction, wherein
at least part of the outer peripheral cup forms part of the first lifter-lowerer by supporting at least part of the cup cleaning member and the center cup from below in at least part of a lifting period in which the outer peripheral cup is lifted by the second lifter-lowerer and a lowering period in which the outer peripheral cup is lowered by the second lifter-lowerer.

9. The coating device according to any one of claims 1 to 7, wherein
the rotation holder rotates the substrate in a first rotation direction when the coating liquid is supplied to the substrate, and
a direction in which the cup rotation driver rotates the center cup is a second rotation direction opposite to the first rotation direction.

10. A coating method of forming a coating film on a substrate by using a coating device, the substrate being at least partially circular, wherein
the coating device further includes
a rotation holder that holds the substrate and rotates the held substrate about a reference axis extending in an upward-and-downward direction,
an outer peripheral cup provided around the substrate held by the rotation holder,
a center cup arranged inwardly of the outer peripheral cup and below the substrate held by the rotation holder, and
a first solvent nozzle that supplies a solvent to a partial area in a circumferential direction of an upper-surface peripheral portion of the substrate rotated by the rotation holder from a predetermined first position above the substrate held by the rotation holder, and
the coating method includes
a first step of forming the coating film on an entire upper surface of one substrate by supplying a coating liquid to an upper surface of the one substrate held and rotated by the rotation holder,
a second step of supplying a solvent from the first solvent nozzle to a partial area in a circumferential direction of an upper-surface peripheral portion of the one substrate held and rotated by the rotation holder after the coating film is formed on the entire upper surface of the one substrate, and
a third step of rotating the center cup about the reference axis after the first step and the second step are performed on the one substrate and until the first step and the second step are performed on a next substrate.
